# EUROPEAN PATENT SPECIFICATION

(11) **EP 3 910 674 B1**
(45) Date of publication and mention of the grant of the patent: **27.08.2025**
(21) Application number: 19909346.9
(22) Date of filing: 09.07.2019
(51) Int. Cl.: H10H 29/39, H10H 29/41

(54) **DISPLAY DEVICE AND MANUFACTURING METHOD THEREFOR**
ANZEIGEVORRICHTUNG UND HERSTELLUNGSVERFAHREN DAFÜR
DISPOSITIF D'AFFICHAGE ET PROCÉDÉ DE FABRICATION DE CELUI-CI

(30) Priority: 09.01.2019 KR 20190002974
(43) Date of publication of application: 17.11.2021
(73) Proprietor: Samsung Display Co., Ltd., Gyeonggi-do 17113 (KR)
(72) Inventor: KANG, Sin Chul, Yongin-si, Gyeonggi-do 17113 (KR); OH, Won Sik, Yongin-si, Gyeonggi-do 17113 (KR); KANG, Jae Woong, Yongin-si, Gyeonggi-do 17113 (KR); MOON, Su Mi, Yongin-si, Gyeonggi-do 17113 (KR); LEE, Yo Han, Yongin-si, Gyeonggi-do 17113 (KR)
(74) Representative: Marks & Clerk LLP
(86) International application number: PCT/KR2019/008423
(87) International publication number: WO 2020/145462

(56) References cited:
- KR-A- 20170 051 764
- KR-A- 20170 080 242
- KR-A- 20180 072 909
- KR-B1- 101 609 376
- KR-B1- 101 609 376
- US-A1- 2016 163 745
- US-A1- 2018 122 836
- US-A1- 2018 175 268

## Description

### Technical Field

Various embodiments of the present disclosure relate to a display device and a method of manufacturing the display device.

### Background Art

Recently, technology for manufacturing a subminiature light emitting element using a material having a reliable inorganic crystal structure and manufacturing a light emitting device using the light emitting element has been developed. For example, technology for forming the light source of a light emitting device using subminiature light emitting elements having a small size ranging from a nanoscale to a microscale is being developed. Such a light emitting device may be used for various electronic devices, such as a display device or a lighting device.

US 2018/122836 A1 describes a light emitting diode display device in which a process time taken in a process of connecting a light emitting device to a pixel circuit is shortened. The light emitting diode display device includes a pixel including a driving thin film transistor (TFT) on a substrate, a first planarization layer covering the pixel, a concave portion in the first planarization layer, a light emitting device in the concave portion and including a first electrode and a second electrode, a second planarization layer covering the first planarization layer and the light emitting device, a pixel electrode electrically connected to the driving TFT and the first electrode of the light emitting device, and a common electrode electrically connected to the second electrode of the light emitting device. The pixel electrode and the common electrode are on the second planarization layer.

US 2018/175268 A1 describes a light emitting diode chip and a light emitting diode display apparatus comprising the same, are disclosed in which a screen defect caused by a defect of the light emitting diode chip is minimized. The light emitting diode chip comprises a semiconductor substrate; first and second light emitting diodes provided on the semiconductor substrate in parallel with each other while having first and second pads; a first electrode commonly connected to the first pad of each of the first and second light emitting diodes; and a second electrode commonly connected to the second pad of each of the first and second light emitting diodes, wherein the first and second light emitting diodes are electrically connected to each other in parallel.

KR 101 609 376 B1 describes a dual-plate type organic electroluminescent device including a first substrate and a second substrate opposed to each other in a display region and a non-display region; a gate wiring and a data wiring for defining a pixel region in a direction perpendicular to the first substrate; a switching transistor formed at each intersection of the gate line and the data line, and a driving transistor connected to the switching transistor in a one-to-one relationship; an interlayer insulating layer covering an upper portion of the switching and driving transistor and having a drain contact hole exposing a drain electrode of the driving transistor and a plurality of groove patterns formed in each pixel region except for the drain contact hole; a connection electrode connected to the drain electrode of the driving transistor over the interlayer insulating film; a first electrode formed on a lower front surface of the second substrate; A buffer pattern covering the auxiliary electrode to a lower portion of the first electrode; a partition wall having an inverted tapered cross section formed at a lower portion thereof overlapping with the buffer pattern; a patterned spacer located on one side of the pixel region, the patterned spacer being spaced apart from the barrier rib; an organic light emitting layer and a second electrode sequentially connected to the first electrode in each pixel region divided by the barrier ribs; a seal pattern for attaching the first and second substrates along the non-display region; and an internal filler interposed for each pixel region excluding an area corresponding to the patterned spacer by the plurality of groove patterns.

KR 2018 0072909 A describes a light emitting device comprising: a substrate; a light emitting element disposed on the substrate and having a first end portion and a second end portion in the longitudinal direction; one or more partition walls disposed on the substrate and spaced apart from the light emitting element; a first reflection electrode disposed adjacent to the first end portion of the light emitting element and a second reflection electrode disposed adjacent to the second end portion of the light emitting element; a first contact electrode connected to the first reflection electrode and the first end portion of the light emitting element, respectively; an insulating layer disposed on the first contact electrode, and including an opening portion exposing the second end portion of the light emitting element and the second reflection electrode to the outside; and a second contact electrode disposed on the insulating layer and connected to the second reflection electrode and the second end portion of the light emitting element through the opening portion, respectively. Thus, light emission efficiency is able to be improved.

### Disclosure

### Technical Problem

A display device is manufactured by forming circuit elements on a substrate and forming light emitting elements on the circuit elements. When even any one of the circuit elements and light emitting elements is defective, the display device may be sorted as a defective product.

Also, when the light emitting elements are formed on the circuit elements, an electromagnetic shield layer may be formed between the circuit elements and the light emitting elements in order to prevent interference by the circuit elements, but this may complicate a process.

The technical object of the present disclosure is to provide a display device that can be manufactured with improved yield while having a simpler structure.

The technical object of the present disclosure is to provide a method of manufacturing a display device capable of improving yield through a more simplified process.

### Technical Solution

The invention is defined by the subject-matter of independent claims 1 and 13. Embodiments are defined in dependent claims 2 to 12 and 14.

In order to accomplish an object of the present disclosure, a display device according to embodiments of the present disclosure includes a first substrate including a first area and a second area located at an edge of the first area; a first electrode and a second electrode disposed on the first substrate and spaced apart from each other; light emitting elements disposed between the first electrode and the second electrode in the first area; a first conductive layer disposed on the first electrode in the second area; a pixel circuit layer disposed on the first conductive layer in the second area and including a transistor coupled to the first conductive layer; a second substrate disposed on the pixel circuit layer; a first contact electrode configured to couple a first end of each of the light emitting elements to the first electrode ; a second contact electrode configured to couple a second end of each of the light emitting elements to the second electrode; and an insulating layer disposed on the first contact electrode and the second contact electrode, wherein a thickness of the first conductive layer is greater than an average thickness of the insulating layer.

According to an embodiment, the display device may further include a first bank pattern interposed between the first substrate and the first electrode in the first area; a second bank pattern interposed between the first substrate and the second electrode in the first area; and a third bank pattern interposed between the first substrate and the first electrode in the second area, and the light emitting elements may be disposed between the first bank pattern and the second bank pattern.

According to an embodiment, the pixel circuit layer may further include a transmissive component disposed to overlap the first area of the first substrate and configured to transmit at least some of light emitted from the light emitting elements.

The display device includes a first contact electrode configured to couple a first end of each of the light emitting elements to the first electrode; and a second contact electrode configured to couple a second end of each of the light emitting elements to the second electrode.

According to an embodiment, the first contact electrode may be interposed between the first electrode and the first conductive layer in the second area.

The display device further includes an insulating layer disposed on the first contact electrode and the second contact electrode, and the insulating layer may not overlap the first conductive layer.

The thickness of the first conductive layer is greater than the average thickness of the insulating layer.

According to an embodiment, the pixel circuit layer may further include a via layer disposed on the first conductive layer; a first transistor electrode disposed on the via layer; and a semiconductor pattern disposed on the first transistor electrode, the first transistor electrode and the semiconductor pattern may form the transistor, and the first conductive layer may come into contact with the first transistor electrode through a contact hole that exposes the first transistor electrode by passing through the via layer.

According to an embodiment, the via layer may include a light-blocking material that absorbs or blocks light emitted from the light emitting elements.

According to an embodiment, the display device may further include a second conductive layer disposed on the second electrode in the second area and spaced apart from the first conductive layer, and the pixel circuit layer may further include a power line disposed on the second conductive layer in the second area and coupled to the second conductive layer.

Also described is a display device, not covered as such by the subject-matter of the claims, configured such that the first substrate includes a plurality of pixel areas configured to display different monochromic colors, each of the pixel areas including the first area and the second area, the first conductive layer is independently disposed in each of the pixel areas, and the second conductive layer is disposed across at least two pixel areas, among the pixel areas.

The transmissive component may cover the second electrode in the second area.

The first substrate may further include a display area in which an image is displayed and a non-display area located on one side of the display area, the display area may include a plurality of pixel areas configured to display different monochromic colors, each of the pixel areas including the first area and the second area, the second electrode may extend to the non-display area, and the pixel circuit layer may further include a power line disposed in the non-display area; and a second conductive layer disposed between the second electrode and the power line in the non-display area and configured to couple the second electrode to the power line.

The first conductive layer may cover the transistor.

The transmissive component may include a color filter material configured to block some wavelength bands of light emitted from the light emitting elements.

The transmissive component may include a quantum dot configured to convert a color of light emitted from the light emitting elements.

The display device may further include a bank disposed along an edge of the first area on the second area of the first substrate and configured to define the first area, and the bank may not overlap the first conductive layer.

The sum of the thickness of the first conductive layer and the thickness of the third bank pattern may be greater than the thickness of the bank.

Each of the light emitting elements may be a rod-type light emitting diode having a size ranging from a nanoscale to a microscale. In order to accomplish an object of the present disclosure, a method of manufacturing a display device according to embodiments of the present disclosure includes preparing a first panel including a light emitting element layer formed on a first substrate; preparing a second panel including a pixel circuit layer formed on a second substrate; and bonding the first panel and the second panel such that the light emitting element layer and the pixel circuit layer come into contact with each other, the light emitting element layer may include a first substrate, first and second electrodes disposed to be spaced apart from each other on the first substrate, and a plurality of light emitting elements disposed between the first and second electrodes, and the pixel circuit layer may include a second substrate, a transistor disposed on the second substrate, and a first conductive layer disposed on the transistor; and a first contact electrode configured to couple a first end of each of the light emitting elements to the first electrode; a second contact electrode configured to couple a second end of each of the light emitting elements to the second electrode; and an insulating layer disposed on the first contact electrode and the second contact electrode, wherein a thickness of the first conductive layer is greater than an average thickness of the insulating layer.

According to an embodiment, the pixel circuit layer may further include a transmissive component overlapping the light emitting elements of the first panel and configured to transmit at least some of light emitted from the light emitting elements.

According to an embodiment, preparing the second panel may include forming the transistor on the second substrate; forming the first conductive layer on the transistor; forming a groove in the pixel circuit layer corresponding to the transmissive component; and forming the transmissive component by supplying a transparent organic material to the groove.

### Advantageous Effects

A display device according to an embodiment of the present disclosure may have a simpler structure by including circuit elements disposed on light emitting elements.

A method of manufacturing a display device according to an embodiment of the present disclosure enables the display device to be manufactured by individually manufacturing a first panel, including light emitting elements, and a second panel, including circuit elements and a conductive layer formed on the circuit elements, and by bonding the first panel and the second panel such that the circuit elements are coupled to the light emitting elements through the conductive layer. Accordingly, the yield of the display device may be improved.

### Description of Drawings

FIG. 1a and FIG. 1b are a perspective view and a sectional view illustrating a light emitting element according to an embodiment of the present disclosure.
FIG. 2a and FIG. 2b are a perspective view and a sectional view illustrating a light emitting element according to another embodiment of the present disclosure.
FIG. 3a and FIG. 3b are a perspective view and a sectional view illustrating a light emitting element according to a further embodiment of the present disclosure.
FIG. 4 is a plan view illustrating a display device according to an embodiment of the present disclosure.
FIGS. 5a to 5c are circuit diagrams illustrating examples of a sub-pixel included in the display device of FIG. 4.
FIG. 6 is a sectional view illustrating an example of the display device of FIG. 4.
FIG. 7 is a plan view illustrating an example of a first panel included in the display device of FIG. 6.
FIGS. 8a to 8d are sectional views illustrating examples of a first panel taken along the line I-I' of FIG. 7.
FIG. 9 is a plan view illustrating an example of a second panel included in the display device of FIG. 6.
FIG. 10 is a sectional view illustrating an example of a second panel taken along the line II-II' of FIG. 9.
FIG. 11 is a sectional view illustrating an example of the display device of FIG. 6.
FIG. 12 is a plan view illustrating another example of the first panel included in the display device of FIG. 6.
FIG. 13 is a sectional view illustrating another example of the first panel taken along the line III-III' of FIG. 12.
FIG. 14 is a sectional view illustrating another example of the display device of FIG. 6.
FIG. 15 is a sectional view illustrating a further example of the first panel taken along the line I-I' of FIG. 7.
FIG. 16 is a sectional view illustrating a further example of the display device of FIG. 6.
FIG. 17 is a plan view illustrating another example of the second panel included in the display device of FIG. 6.
FIG. 18 is a sectional view illustrating another example of the second panel taken along the line IV-IV' of FIG. 17.
FIG. 19 is a sectional view illustrating a further example of the display device of FIG. 6.
FIG. 20 is a plan view illustrating a display device according to another embodiment of the present disclosure.
FIG. 21 is a flowchart illustrating a method of manufacturing a display device according to an embodiment of the present disclosure.
FIGS. 22a to 22d are views for explaining a process of preparing a first panel according to the method of FIG. 21.
FIGS. 23a to 23g are views for explaining a process of preparing a second panel according to the method of FIG. 21.

### Mode for Invention

As the present disclosure allows for various changes and numerous embodiments, particular embodiments will be illustrated in the drawings and described in detail in the written description. However, the present disclosure is not limited to the embodiment to be disclosed below, and may be implemented in various forms.

Meanwhile, some components not directly related to the characteristics of the present disclosure may be omitted in the drawings in order to clearly illustrate the present disclosure. Also, the sizes or ratios of some components in the drawings may be exaggerated. In all of the drawings, the same or similar components are assigned the same reference numerals and symbols as possible although they are illustrated in different drawings, and a repeated description will be omitted.

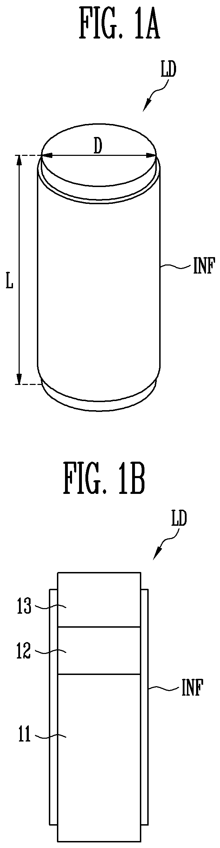

FIG. 1a and FIG. 1b are a perspective view and a sectional view illustrating a light emitting element according to an embodiment of the present disclosure. In FIG. 1a and FIG. 1b, a rod-type light emitting element LD having a cylindrical shape is illustrated, but the type and/or shape of the light emitting element LD according to the present disclosure are (is) not limited thereto.

Referring to FIG. 1a and FIG. 1b, a light emitting element LD may include a first conductive semiconductor layer 11, a second conductive semiconductor layer 13, and an active layer 12 interposed between the first and second conductive semiconductor layers 11 and 13. For example, the light emitting element LD may be formed of a stacked body in which the first conductive semiconductor layer 11, the active layer 12, and the second conductive semiconductor layer 13 are sequentially stacked along one direction.

According to an embodiment, the light emitting element LD may be provided in a rod shape extending along one direction. The light emitting element LD may have a first end and a second end along one direction.

According to an embodiment, one of the first and second conductive semiconductor layers 11 and 13 may be disposed on the first end of the light emitting element LD, and the other one of the first and second conductive semiconductor layers 11 and 13 may be disposed on the second end of the light emitting element LD.

According to an embodiment, the light emitting element LD may be a rod-type light emitting diode manufactured in a rod shape. Here, the rod shape embraces a rod-like shape or a bar-like shape having a longitudinal length greater than a widthwise length (that is, having an aspect ratio greater than 1), such as a cylinder, a polygonal column, or the like, and the shape of the cross-section thereof is not specifically limited. For example the length L of the light emitting element LD may be greater than the diameter D thereof (or the width of the cross-section thereof).

According to an embodiment, the light emitting element LD may have a small size ranging from a nanoscale to a microscale, e.g., a diameter D and/or a length L having a nanoscale or microscale range. However, the size of the light emitting element LD is not limited thereto. For example, the size of the light emitting element LD may be variously changed depending on the design conditions of various devices, e.g., a display device and the like, which use a light emitting device using the light emitting element LD as the light source thereof.

The first conductive semiconductor layer 11 may include at least one n-type semiconductor layer. For example, the first conductive semiconductor layer 11 may include an n-type semiconductor layer that includes one semiconductor material, among InAlGaN, GaN, AlGaN, InGaN, AlN, and InN, and is doped with a first conductive dopant, such as Si, Ge, Sn, or the like. However, the material forming the first conductive semiconductor layer 11 is not limited thereto, and various materials other than that may form the first conductive semiconductor layer 11.

The active layer 12 may be disposed on the first conductive semiconductor layer 11, and may be formed in a single- or multi-quantum well structure. In an embodiment, a clad layer (not illustrated) doped with a conductive dopant may be formed on and/or under the active layer 12. For example, the clad layer may be formed of an AlGaN layer or an InAlGaN layer. According to an embodiment, a material such as AlGaN, AlInGaN, or the like may be used to form the active layer 12, and various materials other than that may form the active layer 12.

When a voltage equal to or higher than a threshold voltage is applied to the opposite ends of the light emitting element LD, electron-hole pairs are combined in the active layer 12, whereby the light emitting element LD may emit light. Light emission of the light emitting element LD is controlled using this principle, whereby the light emitting element LD may be used as the light source of various light emitting devices as well as pixels of a display device.

The second conductive semiconductor layer 13 may be disposed on the active layer 12, and may include a semiconductor layer having a type different from the type of the first conductive semiconductor layer 11. For example, the second conductive semiconductor layer 13 may include at least one p-type semiconductor layer. For example, the second conductive semiconductor layer 13 may include a p-type semiconductor layer that includes at least one semiconductor material, among InAlGaN, GaN, AlGaN, InGaN, AlN, and InN, and is doped with a second conductive dopant, such as Mg or the like. However, the material forming the second conductive semiconductor layer 13 is not limited thereto, and various materials other than that may form the second conductive semiconductor layer 13.

According to an embodiment, the light emitting element LD may further include an insulating film INF provided on the surface thereof. The insulating film INF may be formed on the surface of the light emitting element LD so as to enclose at least the outer circumferential surface of the active layer 12, and in addition thereto, it may further enclose portions of the first and second conductive semiconductor layers 11 and 13. However, the insulating film INF may expose the opposite ends of the light emitting element LD, which have different polarities. For example, the insulating film INF may expose respective one ends of the first and second conductive semiconductor layer 11 and 13, which are located at the opposite ends of the light emitting element LD in a longitudinal direction, e.g., the two bases of the cylinder (that is, the top surface and the bottom surface), rather than covering the same.

According to an embodiment, the insulating film INF may include at least one insulating material, among silicon dioxide (SiO₂), silicon nitride (Si₃N₄), aluminium oxide (Al₂O₃), and titanium dioxide (TiO₂), but is not limited thereto. That is, the material forming the insulating film INF is not specifically limited, and the insulating film INF may be formed of currently known various insulating materials.

In an embodiment, the light emitting element LD may further include an additional component as well as the first conductive semiconductor layer 11, the active layer 12, the second conductive semiconductor layer 13, and/or the insulating film INF. For example, the light emitting element LD may additionally include one or more fluorescent layers, active layers, semiconductor layers and/or electrode layers disposed on one end of each of the first conductive semiconductor layer 11, the active layer 12, and/or the second conductive semiconductor layer 13.

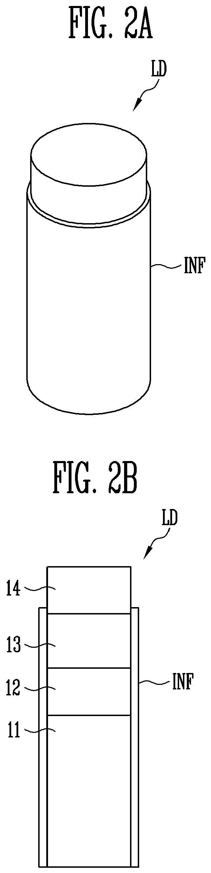

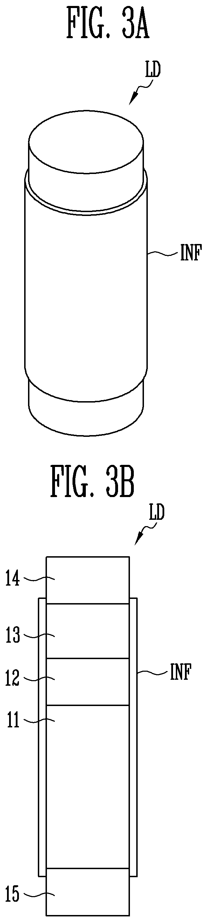

FIG. 2a and FIG. 2b are a perspective view and a sectional view illustrating a light emitting element according to another embodiment of the present disclosure. FIG. 3a and FIG. 3b are a perspective view and a sectional view illustrating a light emitting element according to a further embodiment of the present disclosure.

Referring to FIG. 2a and FIG. 2b, the light emitting element LD may further include at least one electrode layer 14 disposed on one end of the second conductive semiconductor layer 13.

Referring to FIG. 3a and FIG. 3b, the light emitting element LD may further include at least one additional electrode layer 15 disposed on one end of the first conductive semiconductor layer 11.

Each of the electrode layers 14 and 15 may be an ohmic contact electrode, but is not limited thereto. Also, each of the electrode layers 14 and 15 may include metal or a conductive metal oxide, and may be formed of, for example, chromium (Cr), titanium (Ti), aluminium (Al), gold (Au), nickel (Ni), an oxide thereof, an alloy thereof, a transparent electrode material, such as Indium Tin Oxide (ITO), Indium Zinc Oxide (IZO), Zinc Oxide (ZnO), or Indium Tin Zinc Oxide (ITZO), or the like alone or in combination. The electrode layers 14 and 15 may be substantially transparent or translucent. Accordingly, light generated in the light emitting element LD penetrates the electrode layers 14 and 15 and is emitted out of the light emitting element LD.

According to an embodiment, the insulating film INF may partially enclose at least the outer circumferential surfaces of the electrode layers 14 and 15, or may not enclose the same. That is, the insulating film INF may be selectively formed on the surfaces of the electrode layers 14 and 15. Also, the insulating film INF may be formed to expose the opposite ends of the light emitting element LD, which have different polarities, and may expose, for example, at least portions of the electrode layers 14 and 15. However, without limitation thereto, the insulating film INF may not be provided.

The insulating film INF is provided on the surface of the light emitting element LD, e.g., on the surface of the active layer 12, whereby the active layer 12 may be prevented from short-circuiting with at least one electrode (e.g., at least one of contact electrodes coupled to the opposite ends of the light emitting element LD) or the like. Accordingly, the electrical stability of the light emitting element LD may be secured.

Also, because the insulating film INF is formed on the surface of the light emitting element LD, defects on the surface of the light emitting element LD may be minimized, and the lifetime and efficiency of the light emitting element LD may be improved. Furthermore, because the insulating film INF is formed on the surface of the light emitting element LD, even when a plurality of light emitting elements LD are disposed adjacent to each other, undesired short-circuiting between the light emitting elements LD may be prevented.

In an embodiment, the light emitting element LD may be manufactured after going through a surface treatment process (e.g., coating). For example, when a plurality of light emitting elements LD is mixed with a fluidic solution (or solvent) and supplied to each emission area (e.g., the emission area of each pixel), the light emitting elements LD may be evenly distributed, rather than unevenly agglomerated in the solution. Here, the emission area is an area in which light is emitted by the light emitting elements LD, and may be differentiated from a non-emission area in which no light is emitted.

According to embodiments, the insulating film INF itself is formed of a hydrophobic film using a hydrophobic material, or a hydrophobic film made of a hydrophobic material may be additionally formed on the insulating film INF. According to an embodiment, the hydrophobic material may be a material including fluorine so as to exhibit a hydrophobic property. Also, according to an embodiment, the hydrophobic material in the form of a self-assembled monolayer (SAM) may be applied to the light emitting elements LD. In this case, the hydrophobic material may include octadecyl trichlorosilane, fluoroalkyl trichlorosilane, perfluoroalkyl triethoxysilane, or the like. Also, the hydrophobic material may be a commercialized material including fluorine, such as Teflon^{™} or Cytop^{™}, or a material corresponding thereto.

A light emitting device including the light emitting element LD may be used in various kinds of devices requiring a light source, as well as a display device. For example, at least one subminiature light emitting element LD, e.g., a plurality of subminiature light emitting elements LD, each having a nanoscale to microscale size, is disposed in each pixel area of a display panel, and the light source (or light source unit) of each pixel may be formed using the subminiature light emitting elements LD. However, in the present disclosure, the application field of the light emitting element LD is not limited to a display device. For example, the light emitting element LD may also be used in other types of devices requiring a light source, such as a lighting device, and the like.

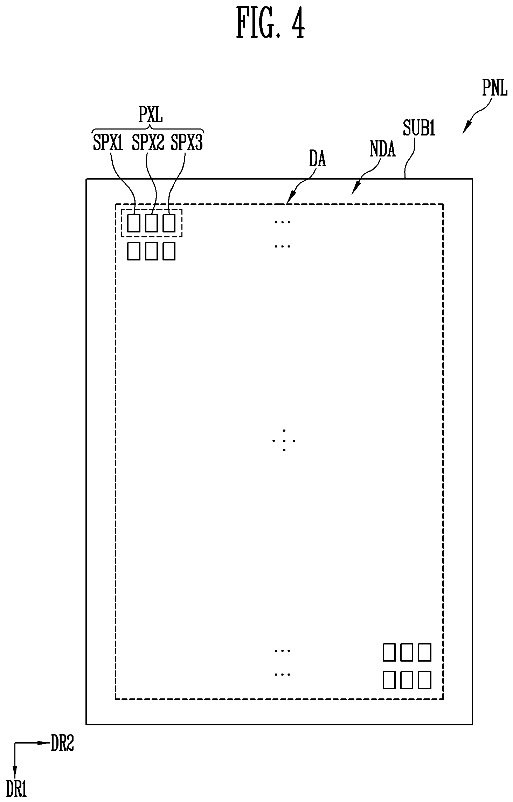

FIG. 4 is a plan view illustrating a display device according to an embodiment of the present disclosure. According to an embodiment, a display device, particularly a display panel PNL provided in the display device, is illustrated in FIG. 4 as an example of a device capable of using the light emitting elements LD described in FIGS. 1a to 3b as the light source thereof. According to an embodiment, the structure of the display panel PNL is simply illustrated in FIG. 4 with focus on a display area DA. However, according to an embodiment, at least one driving circuit (e.g., at least one of a scan driver and a data driver) and/or a plurality of lines may be further disposed on the display panel PNL although not illustrated.

Referring to FIG. 4, the display panel PNL may include a first substrate SUB1 (or a base layer) and a pixel PXL disposed on the first substrate SUB1. Specifically, the display panel PNL and the first substrate SUB1 may include a display area DA in which an image is displayed and a non-display area NDA other than the display area DA.

According to an embodiment, the display area DA may be disposed in the center area of the display panel PNL, and the non-display area NDA may be disposed along the edge of the display panel PNL so as to enclose the display area DA. However, the locations of the display area DA and non-display area NDA are not limited thereto, and the locations thereof may be changed.

The first substrate SUB1 may configure the base member of the display panel PNL. For example, the first substrate SUB1 may configure the base member of a lower panel (e.g., the lower plate of the display panel PNL).

According to an embodiment, the first substrate SUB1 may be a rigid substrate or a flexible substrate, and the material and property thereof are not specifically limited. For example, the first substrate SUB1 may be a rigid substrate made of glass or reinforced glass, or a flexible substrate formed of a thin film made of plastic or metal. Also, the first substrate SUB1 may be a transparent substrate, but is not limited thereto. For example, the first substrate SUB1 may be a translucent substrate, an opaque substrate, or a reflective substrate.

An area on the first substrate SUB1 is defined as the display area DA in which the pixels PXL are disposed, and the remaining area is defined as the non-display area NDA. For example, the first substrate SUB1 may include the display area DA, including a plurality of pixel areas on which pixels PXL are formed, and the non-display area NDA disposed around the display area DA. Various lines and/or embedded circuits coupled to the pixels PXL of the display area DA may be disposed in the non-display area NDA.

The pixel PXL may include at least one light emitting element LD driven by a corresponding scan signal and data signal, e.g., at least one rod-type light emitting diode according to any one of the embodiments of FIGS. 1a to 3b. For example, the pixel PXL may include a plurality of rod-type light emitting diodes having a small size ranging from a nanoscale to a microscale and coupled in parallel to each other. The plurality of rod-type light emitting diodes may form the light source of the pixel PXL.

Also, the pixel PXL may include a plurality of sub-pixels. For example, the pixel PXL may include a first sub-pixel SPX1, a second sub-pixel SPX2, and a third sub-pixel SPX3.

According to an embodiment, the first, second and third sub-pixels SPX1, SPX2 and SPX3 may emit different colors of light. For example, the first sub-pixel SPX1 may be a red sub-pixel emitting red light, the second sub-pixel SPX2 may be a green sub-pixel emitting green light, and the third sub-pixel SPX3 may be a blue sub-pixel emitting blue light. However, the color, type, and/or number of sub-pixels forming the pixel PXL are not specifically limited, and for example, the color of light emitted by each of the sub-pixels may be variously changed. Also, an embodiment in which the pixels PXL are arranged in a stripe form in the display area DA is illustrated in FIG. 4, but the present disclosure is not limited thereto. For example, the pixels PXL may be disposed to have currently known various pixel arrangement forms.

In an embodiment, the pixel PXL (or, each of the sub-pixels) may be formed of an active pixel. However, the type, structure, and/or driving method of the pixel PXL applicable to the display device of the present disclosure are not specifically limited. For example, the pixel PXL may be formed of the pixel of a display device having currently known various passive or active structures.

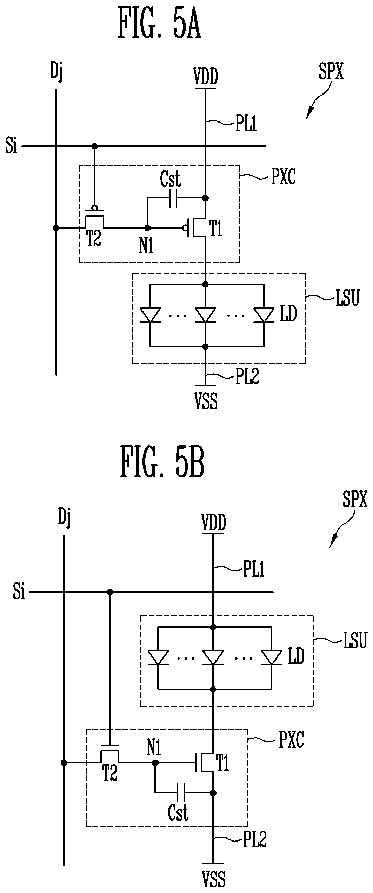

FIGS. 5a to 5c are circuit diagrams illustrating examples of a sub-pixel included in the display device of FIG. 4. The sub-pixel SPX illustrated in FIGS. 5a to 5c may be any one of the first, second and third sub-pixels SPX1, SPX2 and SPX3 provided in the display panel PNL of FIG. 4, and the first, second and third sub-pixels SPX1, SPX2 and SPX3 may have substantially the same or similar structures. Therefore, the first, second and third sub-pixels SPX1, SPX2 and SPX3 are referred to in common as a sub-pixel SPX in FIGS. 5a to 5c.

First, referring to FIG. 5a, the sub-pixel SPX includes a light source unit LSU configured to emit light with luminance corresponding to a data signal. Also, the sub-pixel SPX may selectively further include a pixel circuit PXC for driving the light source unit LSU.

According to an embodiment, the light source unit LSU may include a plurality of light emitting elements LD electrically coupled between a first power supply VDD and a second power supply VSS. In an embodiment, the light emitting elements LD may be coupled in parallel to each other, but are not limited thereto. For example, the plurality of light emitting elements LD may be coupled in series-parallel combination structure between the first power supply VDD and the second power supply VSS.

The first and second power supplies VDD and VSS may have different potentials so as to enable the light emitting elements LD to emit light. For example, the first power supply VDD may be set as a high-potential power supply, and the second power supply VSS may be set as a low-potential power supply. Here, the difference in potential between the first and second power supplies VDD and VSS may be set equal to or higher than the threshold voltage of the light emitting elements LD during at least the emission period of the sub-pixel SPX.

Meanwhile, an embodiment in which the light emitting elements LD are coupled in parallel to each other in the same direction (e.g., a forward direction) between the first power supply VDD and the second power supply VSS is illustrated in FIG. 5a, but the present disclosure is not limited thereto. For example, some of the light emitting elements LD are coupled in the forward direction between the first and second power supplies VDD and VSS and form each effective light source, and the others may be coupled in the reverse direction. In another example, at least one sub-pixel SPX may include only a single light emitting element LD (e.g., a single effective light source coupled in the forward direction between the first and second power supplies VDD and VSS) .

According to an embodiment, the first ends of the respective light emitting elements LD may be coupled in common to a corresponding pixel circuit PXC through a first electrode, and may be coupled to the first power supply VDD through the pixel circuit PXC and a first power line PL1. The second ends of the respective light emitting elements LD may be coupled in common to the second power supply VSS through a second electrode and a second power line PL2.

The light source unit LSU may emit light with luminance corresponding to a driving current supplied through the corresponding pixel circuit PXC. Accordingly, a predetermined image may be displayed in the display area DA.

The pixel circuit PXC may be coupled to the scan line Si and data line Dj of the corresponding sub-pixel SPX. For example, when the sub-pixel SPX is disposed in the i-th row and the j-th column of the display area DA, the pixel circuit PXC of the sub-pixel SPX may be coupled to the i-th scan line Si and j-th data line Dj of the display area DA. The pixel circuit PXC may include first and second transistors T1 and T2 and a storage capacitor Cst.

The first transistor T1 (or a driving transistor) may be coupled between the first power supply VDD and the light source unit LSU. The gate electrode of the first transistor T1 may be coupled to a first node N1. The first transistor T1 may control a driving current supplied to the light source unit LSU in response to the voltage of the first node N1.

The second transistor T2 (or a switching transistor) may be coupled between the data line Dj and the first node N1. The gate electrode of the second transistor T2 may be coupled to the scan line Si.

The second transistor T2 is turned on in response to a scan signal having a gate-on voltage (e.g., a low voltage) from the scan line Si, thereby electrically coupling the data line Dj to the first node N1.

For each frame period, a data signal of the corresponding frame is supplied to the data line Dj, and the data signal may be transmitted to the first node N1 via the second transistor T2. Accordingly, the storage capacitor Cst may be charged with a voltage corresponding to the data signal.

The first electrode of the storage capacitor Cst may be coupled to the first power supply VDD, and the second electrode thereof may be coupled to the first node N1. The storage capacitor Cst may be charged with a voltage corresponding to the data signal supplied to the first node N1 during each frame period, and may maintain the charged voltage until the data signal of the next frame is supplied.

Meanwhile, all of the transistors included in the pixel circuit PXC, e.g., the first and second transistors T1 and T2, are illustrated as P-type transistors in FIG. 5a, but the present disclosure is not limited thereto. For example, at least one of the first and second transistors T1 and T2 may be changed to an N-type transistor.

For example, as illustrated in FIG. 5b, all of the first and second transistors T1 and T2 may be N-type transistors. In this case, the gate-on voltage of a scan signal for writing the data signal, supplied to the data line Dj for each frame period, to the sub-pixel SPX may be a high-level voltage. Similarly, the voltage of the data signal for turning on the first transistor T1 may be a voltage having a waveform reversed to that in the embodiment of FIG. 5a. For example, in the embodiment of FIG. 5b, a data signal having a higher voltage level may be supplied as the grayscale value to be represented increases.

The sub-pixel SPX illustrated in FIG. 5b is substantially similar to the sub-pixel SPX of FIG. 5a in terms of configuration and operation, except that the location at which some circuit elements are coupled and the voltage level of control signals (e.g., the scan signal and the data signal) are changed depending on a change in the type of the transistor. For example, in the sub-pixel SPX illustrated in FIG. 5B, the light source unit LSU is connected between the first power supply VDD and the first electrode of the first transistor T1, the first transistor T1 is connected between the light source unit LSU and the second power supply VSS, and the storage capacitor Cst is connected between the first node N1 and the second electrode of the first transistor T1. Accordingly, a detailed description of the sub-pixel SPX of FIG. 5b will be omitted.

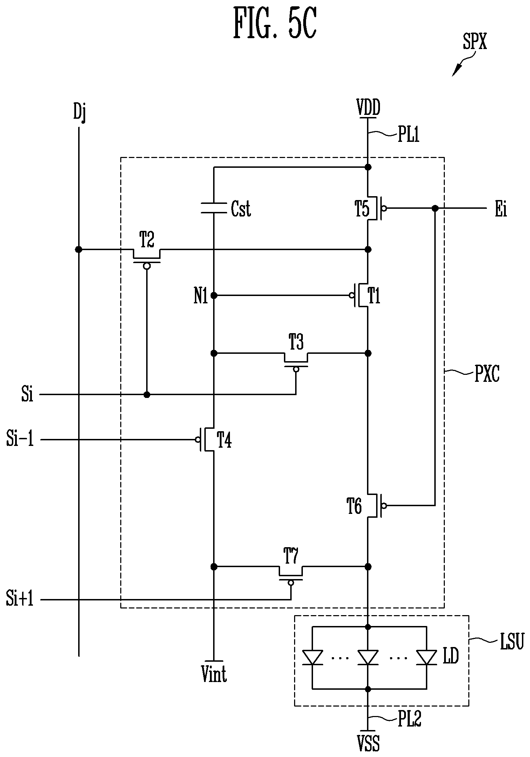

Meanwhile, the structure of the pixel circuit PXC is not limited to the embodiments illustrated in FIG. 5a and FIG. 5b. That is, the pixel circuit PXC may be formed of a pixel circuit having currently known various structures and/or driving methods. For example, the pixel circuit PXC may be formed like the embodiment illustrated in FIG. 5c.

Referring to FIG. 5c, the pixel circuit PXC may be further coupled to at least one additional scan line (or control line) as well as the corresponding scan line Si. For example, the pixel circuit PXC of the sub-pixel SPX disposed in the i-th row of the display area DA may be further coupled to the (i-1)-th scan line Si-1 and/or the (i+1)-th scan line Si+1. Also, according to an embodiment, the pixel circuit PXC may be further coupled to a power supply other than the first and second power supplies VDD and VSS. For example, the pixel circuit PXC may also be coupled to an initialization power supply Vint. According to an embodiment, the pixel circuit PXC may include first to seventh transistors T1 to T7 and a storage capacitor Cst.

The first transistor T1 may be coupled between the first power supply VDD and a light source unit LSU. The first electrode (e.g., the source electrode) of the first transistor T1 may be coupled to the first power supply VDD through the fifth transistor T5 and a first power line PL1, and the second electrode (e.g., the drain electrode) of the first transistor T1 may be coupled to the first electrode of the light source unit LSU (e.g., the first electrode of the corresponding sub-pixel SPX) via the sixth transistor T6. The gate electrode of the first transistor T1 may be coupled to a first node N1. The first transistor T1 may control a driving current supplied to the light source unit LSU in response to the voltage of the first node N1.

The second transistor T2 may be coupled between the data line Dj and the first electrode of the first transistor T1. The gate electrode of the second transistor T2 may be coupled to the corresponding scan line Si. The second transistor T2 is turned on when a scan signal having a gate-on voltage (e.g., a low-level voltage) is supplied from the scan line Si, thereby electrically coupling the data line Dj to the first electrode of the first transistor T1. Accordingly, when the second transistor T2 is turned on, the data signal supplied from the data line Dj may be transmitted to the first transistor T1 (e.g., the first transistor T1 may be diode-connected).

The third transistor T3 may be coupled between the second electrode (e.g., the drain electrode) of the first transistor T1 and the first node N1. The gate electrode of the third transistor T3 may be coupled to the corresponding scan line Si. The third transistor T3 is turned on when a scan signal having a gate-on voltage is supplied from the scan line Si, thereby coupling the first transistor T1 in a diode form.

The fourth transistor T4 may be coupled between the first node N1 and the initialization power supply Vint. The gate electrode of the fourth transistor T4 may be coupled to the previous scan line, e.g., the (i-1)-th scan line Si-1. The fourth transistor T4 is turned on when a scan signal having a gate-on voltage is supplied to the (i-1)-th scan line Si-1, thereby transmitting the voltage of the initialization power supply Vint to the first node N1. Here, the voltage of the initialization power supply Vint may be equal to or lower than the lowest voltage of the data signal.

The fifth transistor T5 may be coupled between the first power supply VDD and the first transistor T1. The gate electrode of the fifth transistor T5 may be coupled to a corresponding emission control line, e.g., the i-th emission control line Ei. The fifth transistor T5 is turned off when an emission control signal having a gate-off voltage (e.g., a high voltage) is supplied to the emission control line Ei, and may be turned on when an emission control signal having a gate-on voltage (e.g., a low voltage) is supplied to the emission control line Ei.

The sixth transistor T6 may be coupled between the first transistor T1 and the first electrode of the light source unit LSU. The gate electrode of the sixth transistor T6 may be coupled to the corresponding emission control line, e.g., the i-th emission control line Ei. The sixth transistor T6 is turned off when an emission control signal having a gate-off voltage is supplied to the emission control line Ei, and may be turned on when an emission control signal having a gate-on voltage (e.g., a low voltage) is supplied to the emission control line Ei.

The seventh transistor T7 may be coupled between the first electrode of the light source unit LSU and the initialization power supply Vint. The gate electrode of the seventh transistor T7 may be coupled to any one of scan lines of the next stage, e.g., the (i+1)-th scan line Si+1. The seventh transistor T7 is turned on when a scan signal having a gate-on voltage is supplied to the (i+1)-th scan line Si+1, thereby supplying the voltage of the initialization power supply Vint to the first electrode of the light source unit LSU. In this case, for each initialization period during which the voltage of the initialization power supply Vint is transmitted to the light source unit LSU, the voltage of the first electrode of the light source unit LSU may be initialized.

The control signal for controlling the operation of the seventh transistor T7 may be variously changed. For example, the gate electrode of the seventh transistor T7 may be alternatively coupled to the scan line of the corresponding horizontal line, that is, the i-th scan line Si. In this case, the seventh transistor T7 is turned on when a scan signal having a gate-on voltage is supplied to the i-th scan line Si, thereby supplying the voltage of the initialization power supply Vint to the first electrode of the light source unit LSU.

The storage capacitor Cst may be coupled between the first power supply VDD and the first node N1. The storage capacitor Cst may store a voltage corresponding to the data signal supplied to the first node N1 in each frame period and the threshold voltage of the first transistor T1.

Meanwhile, all of the transistors included in the pixel circuit PXC, e.g., the first to seventh transistors T1 to T7, are illustrated as P-type transistors in FIG. 5c, but the present disclosure is not limited thereto. For example, at least one of the first to seventh transistors T1 to T7 may be changed to an N-type transistor.

Also, the structure of the sub-pixel SPX applicable to the present disclosure is not limited to the embodiments illustrated in FIGS. 5a to 5c, and the sub-pixel SPX may have currently known various structures. For example, the pixel circuit PXC included in the sub-pixel SPX may be formed of a pixel circuit having currently known various structures and/or driving methods. Also, the sub-pixel SPX may be formed in a passive light emitting display device, or the like. In this case, the pixel circuit PXC is omitted, and each of the first and second electrodes of the light source unit LSU may be directly coupled to the scan line Si, the data line Dj, the power line, and/or the control line.

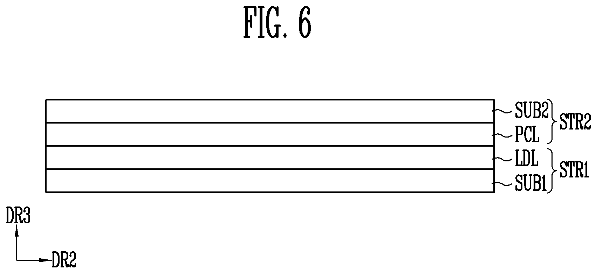

FIG. 6 is a sectional view illustrating an example of the display device of FIG. 4.

Referring to FIG. 6, the display device (or the display panel PNL of FIG. 4) may include a first substrate SUB1, a light emitting element layer LDL (or a display element layer), a pixel circuit layer PCL (or a circuit element layer), and a second substrate SUB2. Hereinbelow, a surface of the display device on which an image is displayed (e.g., the second substrate SUB2) is defined as an upper surface, and the other surface facing the upper surface (e.g., the first substrate SUB1) is defined as a lower surface. In this case, a third direction DR3 may be a direction from the lower surface to the upper surface of the display device, that is, the direction towards the upper portion of the display device.

The light emitting element layer LDL may be disposed on the first substrate SUB1, the pixel circuit layer PCL may be disposed on the light emitting element layer LDL, and the second substrate SUB2 may be disposed on the pixel circuit layer PCL. Here, the light emitting element layer LDL may include the light source unit LSU (or light emitting elements LD) described with reference to FIGS. 5a to 5c, and the pixel circuit layer PCL may include the pixel circuit PXC described with reference to FIGS. 5a to 5c.

As to be described later, the first substrate SUB1 and the light emitting element layer LDL may form a first panel STR1 (or a first structure, a lower panel), and the pixel circuit layer PCL and the second substrate SUB2 may form a second panel STR2 (or a second structure, an upper panel). The first panel STR1 and the second panel STR2 may be manufactured independently of each other, and may form a single display device through a bonding process.

Hereinbelow, the first panel STR1, the second panel STR2, and the display panel PNL in which they are combined will be sequentially described.

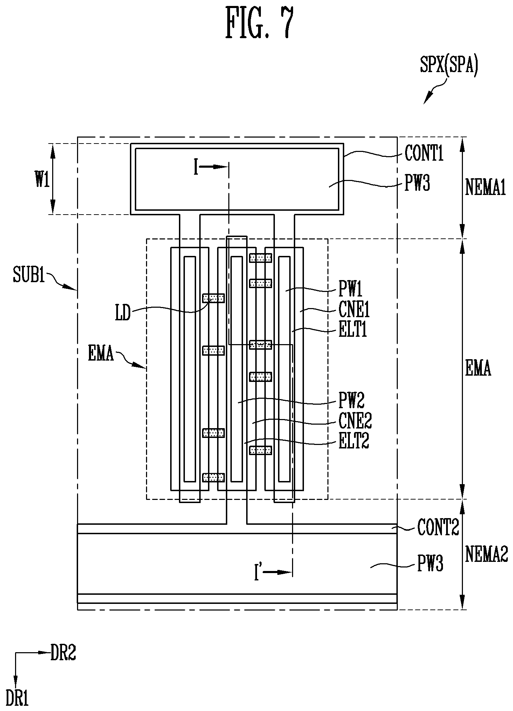

FIG. 7 is a plan view illustrating an example of the first panel included in the display device of FIG. 6. In FIG. 7, the structure of a sub-pixel SPX is illustrated based on the light emitting element layer LDL corresponding to the sub-pixel SPX (e.g., the first sub-pixel SPX1) included in the display device of FIG. 4.

Referring to FIG. 7, the sub-pixel SPX may include a first electrode ELT1 and a second electrode ELT2, disposed to be spaced apart from each other in the sub-pixel area SPA, and at least one light emitting element LD coupled between the first and second electrodes ELT1 and ELT2.

According to an embodiment, the first electrode ELT1 and the second electrode ELT2 may be disposed to be spaced apart from each other in the sub-pixel area SPA, and may be disposed such that at least portions thereof face each other. For example, the first and second electrodes ELT1 and ELT2 may respectively extend along a first direction DR1, and may be disposed in parallel to each other while being spaced a predetermined distance apart from each other along a second direction DR2, which is substantially perpendicular to or crossing the first direction DR1. However, the present disclosure is not limited thereto. For example, the shapes and/or the arrangement relationship of the first and second electrodes ELT1 and ELT2 may be variously changed.

The first electrode ELT1 may be electrically coupled to a first connection electrode CONT1 (or a first connection line) extending in the second direction DR2. The first connection electrode CONT1 may be coupled to the pixel circuit PXC (e.g., the first transistor T1) described with reference to FIGS. 5a to 5c.

The second electrode ELT2 may be electrically coupled to a second connection electrode CONT2 (or a second connection line) extending in the second direction DR2. The second connection electrode CONT2 extends to an adjacent sub-pixel (e.g., to the second and third sub-pixels SPX2 and SPX3 based on the first sub-pixel SPX1 described with reference to FIG. 4), and may also extend to the non-display area (NDA, cf. FIG. 4).

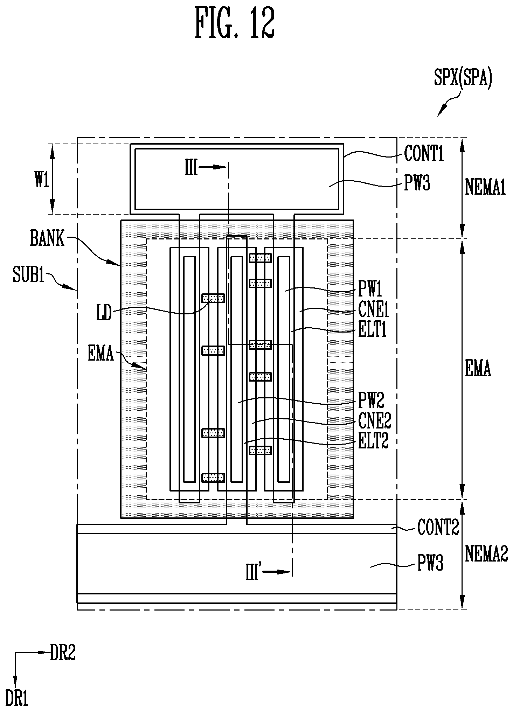

The sub-pixel area SPA may include an emission area EMA in which at least one pair of a first electrode ELT1 and a second electrode ELT2 and at least one light emitting element LD coupled between the first and second electrodes ELT1 and ELT2 are disposed. According to an embodiment, the emission area EMA is a unit area in which a single color of light is emitted, is differentiated from an emission area in which another single color of light is emitted, and may be defined by a bank to be described later (cf. FIG. 12), or the like.

According to an embodiment, each of the first and second electrodes ELT1 and ELT2 may have a single-layer or multi-layer structure. For example, the first electrode ELT1 may have a multi-layer structure including a first reflective electrode and a first conductive capping layer, and the second electrode ELT2 may have a multi-layer structure including a second reflective electrode and a second conductive capping layer.

According to an embodiment, the first electrode ELT1 may be coupled to the first connection electrode CONT1. The first electrode ELT1 may be integrally coupled to the first connection electrode CONT1. For example, the first electrode ELT1 may be formed as at least one branch diverging from the first connection electrode CONT1. When the first electrode ELT1 and the first connection electrode CONT1 are formed as a single body, the first connection electrode CONT1 may be regarded as a portion of the first electrode ELT1. However, the present disclosure is not limited thereto. For example, in another embodiment of the present disclosure, the first electrode ELT1 and the first connection electrode CONT1 are individually formed, and may be electrically coupled to each other through at least one contact hole or via hole that is not illustrated.

According to an embodiment, the first connection electrode CONT1 may have a single-layer or multi-layer structure. For example, the first connection electrode CONT1 may include a first sub-connection electrode integrally coupled to the first reflective electrode of the first electrode ELT1 and a second sub-connection electrode integrally coupled to the first conductive capping layer of the first electrode ELT1. According to an embodiment, the first connection electrode CONT1 may have the same cross-sectional structure (or stack structure) as the first electrode ELT1, but is not limited thereto.

According to an embodiment, the second electrode ELT2 may be coupled to the second connection electrode CONT2. For example, the second electrode ELT2 may be integrally coupled to the second connection electrode CONT2. For example, the second electrode ELT2 may be formed as at least one branch diverging from the second connection electrode CONT2. When the second electrode ELT2 and the second connection electrode CONT2 are formed as a single body, the second connection electrode CONT2 may be regarded as a portion of the second electrode ELT2. However, the present disclosure is not limited thereto. For example, in another embodiment of the present disclosure, the second electrode ELT2 and the second connection electrode CONT2 are individually formed, and may be electrically coupled to each other through at least one contact hole or via hole that is not illustrated.

According to an embodiment, similar to the first connection electrode CONT1, the second connection electrode CONT2 may have a single-layer or multi-layer structure.

A first bank pattern PW1 may be disposed under the first electrode ELT1 while overlapping a portion of the first electrode ELT1, and a second bank pattern PW2 may be disposed under the second electrode ELT2 while overlapping a portion of the second electrode ELT2. The first and second bank patterns PW1 and PW2 are disposed to be spaced apart from each other in the emission area EMA, and may make portions of the first and second electrodes ELT1 and ELT2 protrude in the upward direction. For example, the first electrode ELT1 may be disposed on the first bank pattern PW1 and thereby protrude in the direction of the height of the first substrate SUB1 (or in the third direction DR3, the thickness direction) by the first bank pattern PW1, and the second electrode ELT2 may be disposed on the second bank pattern PW2 and thereby protrude in the direction of the height of the first substrate SUB1 by the second bank pattern PW2.

A third bank pattern PW3 may be disposed under the first and second connection electrodes CONT1 and CONT2 while overlapping the first connection electrode CONT1 and the second connection electrode CONT2. The third bank pattern PW3 may make portions of the first and second connection electrodes CONT1 and CONT2 protrude in the upward direction (or in the third direction DR3).

In embodiments, the width W1 of each of the first and second connection electrodes CONT1 and CONT2 (e.g., the width of the first and second connection electrodes CONT1 and CONT2in the first direction DR1) may be greater than the width of each of the first and second electrodes ELT1 and ELT2 (e.g., the width of each of the first and second electrodes ELT1 and ELT2 in the second direction DR2).

As to be described later, the first and second connection electrodes CONT1 and CONT2 come into direct contact with the pixel circuit layer PCL of the second panel STR2 through a bonding process, and each of the first and second connection electrodes CONT1 and CONT2 may have a relatively large width such that the first and second connection electrodes CONT1 and CONT2 are coupled to the pixel circuit layer PCL of the second panel STR2 even when an alignment error between the first panel STR1 and the second panel STR2 described with reference to FIG. 6 occurs. For example, because each of the first and second connection electrodes CONT1 and CONT2 has a relatively large width, the total area occupied by the first and second connection electrodes CONT1 and CONT2 in the sub-pixel area SPA may be greater than the area occupied by the pixel circuit (PXC, cf. FIG. 5a) in the pixel circuit layer PCL, and may cover the pixel circuit PXC in the plan view.

According to an embodiment, at least one light emitting element LD, e.g., a plurality of light emitting elements LD, may be arranged between the first and second electrodes ELT1 and ELT2 of the sub-pixel SPX. The plurality of light emitting elements LD may be coupled in parallel to each other in the emission area EMA in which the first electrode ELT1 and the second electrode ELT2 are disposed to face each other.

Meanwhile, the light emitting elements LD are illustrated as being aligned in the second direction DR2, e.g., in the horizontal direction, between the first and second electrodes ELT1 and ELT2 in FIG. 7, but the direction in which the light emitting elements LD are arranged is not limited thereto. For example, at least one of the light emitting elements LD may be arranged in a diagonal direction.

Each of the light emitting elements LD may be electrically coupled between the first and second electrodes ELT1 and ELT2 of the sub-pixel SPX. For example, the first end of each of the light emitting elements LD may be electrically coupled to the first electrode ELT1, and the second end of each of the light emitting elements LD may be electrically coupled to the second electrode ELT2.

In an embodiment, the first end of each of the light emitting elements LD may be electrically coupled to the first electrode ELT1 through at least one contact electrode, e.g., a first contact electrode CNE1, rather than being directly disposed on the first electrode ELT1. However, the present disclosure is not limited thereto. For example, in another embodiment of the present disclosure, the first ends of the light emitting elements LD come into direct contact with the first electrode ELT1, thereby being electrically coupled to the first electrode ELT1.

Similarly, the second end of each of the light emitting elements LD may be electrically coupled to the second electrode ELT2 through at least one contact electrode, e.g., a second contact electrode CNE2, rather than being directly disposed on the second electrode ELT2. However, the present disclosure is not limited thereto. For example, in another embodiment of the present disclosure, the second end of each of the light emitting elements LD comes into direct contact with the second electrode ELT2, thereby being electrically coupled to the second electrode ELT2.

According to an embodiment, each of the light emitting elements LD may be a light emitting diode using a material of an inorganic crystal structure and having a subminiature size, e.g., a small size ranging from a nanoscale to a microscale. For example, each of the light emitting elements LD may be a subminiature rod-type light emitting diode having a size ranging from a nanoscale to a microscale, illustrated in any one of FIGS. 1a to 3b. However, the type of the light emitting elements LD applicable to the present disclosure is not limited thereto. For example, the light emitting elements LD are formed using a growth method, and may be, for example, light emitting diodes in a core-shell structure, each having a size ranging from a nanoscale to a microscale.

According to an embodiment, the light emitting elements LD may be prepared in a diffused form in a predetermined solution, and then be supplied to the emission area EMA of each sub-pixel SPX through an inkjet printing method, a slit coating method, or the like. For example, the light emitting elements LD may be supplied to the emission area EMA in the state in which they are mixed with a volatile solvent. Here, when predetermined voltages are supplied to the first and second electrodes ELT1 and ELT2 of the sub-pixel SPX, an electric field is formed between the first and second electrodes ELT1 and ELT2, whereby the light emitting elements LD are self-aligned between the first and second electrodes ELT1 and ELT2. After the light emitting elements LD are aligned, the solvent is removed by volatizing the same or using another method, whereby the light emitting elements LD may be stably arranged between the first and second electrodes ELT1 and ELT2. Also, the first contact electrode CNE1 and the second contact electrode CNE2 are formed on the first ends and second ends of the light emitting elements LD, whereby the light emitting elements LD may be stably coupled between the first and second electrodes ELT1 and ELT2.

Because neither a circuit element nor a line is disposed between the first substrate SUB1 and the first and second electrodes ELT1 and ELT2, interference caused due to a circuit element, a conductive pattern, or the like may be eliminated when an electric field is formed between the first and second electrodes ELT1 and ELT2. Accordingly, the efficiency of alignment of the light emitting elements LD may be relatively improved.

According to an embodiment, the first contact electrode CNE1 is formed on the first ends of the light emitting elements LD and at least a portion of the first electrode ELT1 corresponding thereto, thereby physically and/or electrically coupling the first ends of the light emitting elements LD to the first electrode ELT1. Similarly, the second contact electrode CNE2 is formed on the second ends of the light emitting elements LD and at least a portion of the second electrode ELT2 corresponding thereto, thereby physically and/or electrically coupling the second ends EP2 of the light emitting elements LD to the second electrode ELT2.

The light emitting elements LD disposed in the sub-pixel area SPA are collected, thereby forming the light source of the corresponding sub-pixel SPX. For example, when a driving current flows in at least one sub-pixel SPX during each frame period, the light emitting elements LD coupled in the forward direction between the first and second electrodes ELT1 and ELT2 of the sub-pixel SPX emit light, thereby emitting light with luminance corresponding to the driving current.

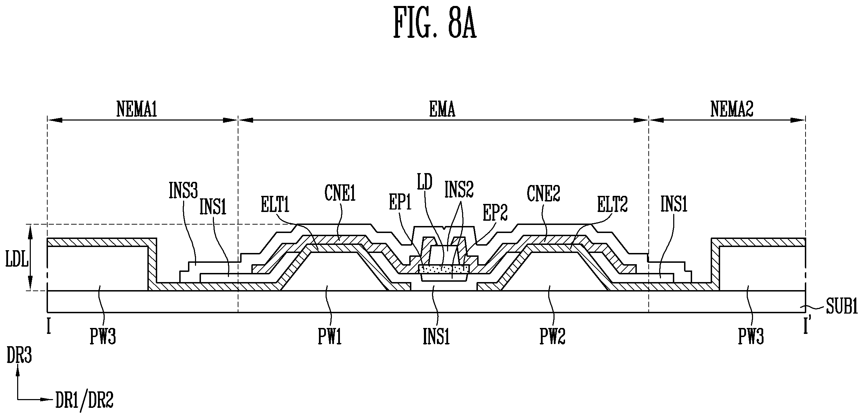

FIGS. 8a to 8d are sectional views illustrating an example of the first panel taken along the line I-I' of FIG. 7. In FIGS. 8a to 8d, any one sub-pixel area SPA (e.g., a first sub-pixel area SPA1) formed on the first panel STR1 is illustrated. According to an embodiment, the above-described first, second and third sub-pixels SPX1, SPX2 and SPX3 may have substantially the same or similar cross-sectional structures. Accordingly, in FIGS. 8a to 8d, a description will be made with focus on the structure of a sub-pixel SPX embracing the first, second and third sub-pixels SPX1, SPX2 and SPX3 for the convenience of description.

First, referring to FIG. 8a, a light emitting element layer LDL may be disposed on a first substrate SUB1. According to an embodiment, the light emitting element layer LDL may be formed in the entire display area DA of a display panel PNL. For example, the light emitting element layer LDL may be formed on one surface of the first substrate SUB1.

The light emitting element layer LDL may include first to third bank patterns PW1, PW2 and PW3. The light emitting element layer LDL includes first and second electrodes ELT1 and ELT2. The light emitting element layer LDL may include a first insulating layer INS1. The light emitting element layer LDL includes light emitting elements LD. The light emitting element layer LDL may include a second insulating layer INS2. The light emitting element layer includes first and second contact electrodes CNE1 and CNE2, and a third insulating layer INS3, which may be sequentially disposed and/or formed on the first substrate SUB1.

The first and second bank patterns PW1 and PW2 may be disposed on the first substrate SUB1 in an emission area EMA. The first and second bank patterns PW1 and PW2 may be disposed to be spaced apart from each other in the emission area EMA.

The third bank pattern PW3 may be disposed on the first substrate SUB1 in non-emission areas NEMA1 and NEMA2. The third bank pattern PW3 is spaced apart from the first and second bank patterns PW1 and PW2, but is not limited thereto.

The first to third bank patterns PW1, PW2 and PW3 may protrude in the third direction DR3 (that is, in the height direction) on the first substrate SUB1. According to an embodiment, the first and second bank patterns PW1 and PW2 may have substantially the same height, but are not limited thereto. For example, the third bank pattern PW3 may have a height greater than the heights of the first and second bank patterns PW1 and PW2.

According to an embodiment, the first bank pattern PW1 may be disposed between the first substrate SUB1 and the first electrode ELT1. The first bank pattern PW1 may be disposed to be adjacent to the first ends EP1 of the light emitting elements LD. For example, one side surface of the first bank pattern PW1 is located at a distance close to the first ends EP1 of the light emitting elements LD, and may be disposed to face the first ends EP1.

According to an embodiment, the second bank pattern PW2 may be disposed between the first substrate SUB1 and the second electrode ELT2. The second bank pattern PW2 may be disposed to be adjacent to the second ends EP2 of the light emitting elements LD. For example, one side surface of the second bank pattern PW2 is located at a distance close to the second ends EP2 of the light emitting elements LD, and may be disposed to face the second ends EP2.

According to an embodiment, the third bank pattern PW3 may be disposed between the first substrate SUB1 and the first electrode ELT1 in the first non-emission area NEMA1, and may be disposed between the first substrate SUB1 and the second electrode ELT2 in the second non-emission area NEMA2.

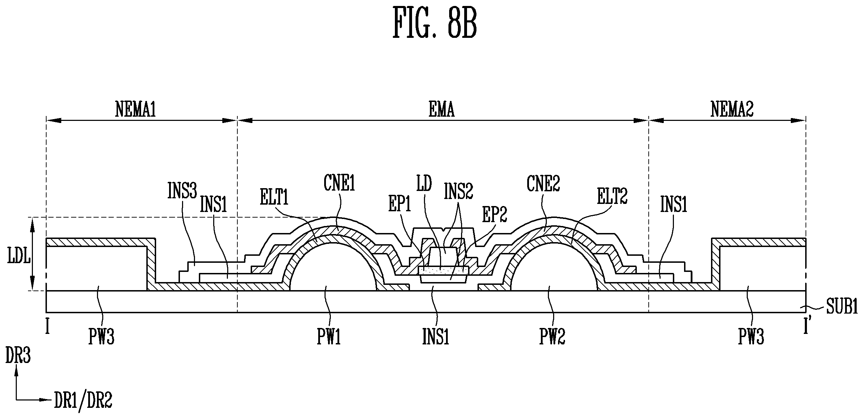

According to an embodiment, the first to third bank patterns PW1, PW2 and PW3 may have various shapes. For example, the first and second bank patterns PW1 and PW2 may have a cross-sectional shape of a trapezoid, the width of which decreases as being closer to the top thereof, as illustrated in FIG. 8a. In this case, each of the first and second bank patterns PW1 and PW2 may have a slope in at least one side surface thereof. In another example, the first and second bank patterns PW1 and PW2 may have a cross-section of a semi-circle or a semi-ellipse, the width of which decreases as being closer to the top thereof, as illustrated in FIG. 8b. In this case, each of the first and second bank patterns PW1 and PW2 may have a curved surface in at least one side surface thereof. That is, the shapes of the first to third bank patterns PW1, PW2 and PW3 are not specifically limited in the present disclosure, and may be variously changed. Also, according to an embodiment, at least one of the first and second bank patterns PW1 and PW2 may be omitted, or the location thereof may be changed.

Referring again to FIG. 8a, the first to third bank patterns PW1, PW2 and PW3 may include an insulating material including an inorganic material and/or an organic material. For example, the first to third bank patterns PW1, PW2 and PW3 may include at least one layer of an inorganic film including currently known various inorganic insulating materials as well as SiNx, SiOx or the like. Alternatively, the first to third bank patterns PW1, PW2 and PW3 may include at least one layer of an organic film including currently known various organic insulating materials and/or a photoresist film, or may be formed of a single-layer or multi-layer insulator compositely including organic/inorganic materials. That is, the materials forming the first to third bank patterns PW1, PW2 and PW3 may be variously changed.

In an embodiment, the first and second bank patterns PW1 and PW2 may function as reflective members. For example, the first and second bank patterns PW1 and PW2 and the first and second electrodes ELT1 and ELT2 provided thereon may function as reflective members for improving the light efficiency of a pixel PXL by inducing light emitted from the respective light emitting elements LD to travel in a desired direction.

The first and second electrodes ELT1 and ELT2 may be disposed on the first and second bank patterns PW1 and PW2, respectively. The first and second electrodes ELT1 and ELT2 may be disposed to be spaced apart from each other in the emission area EMA. Also, the first and second electrodes ELT1 and ELT2 (or the first and second connection electrodes CONT1 and CONT2, cf. FIG. 7) may be disposed on the third bank pattern PW3.

According to an embodiment, the first and second electrodes ELT1 and ELT2 respectively disposed on the first and second bank patterns PW1 and PW2 may have shapes corresponding to the respective shapes of the first and second bank patterns PW1 and PW2. For example, the first and second electrodes ELT1 and ELT2 may protrude in the direction of the height (or in the thickness direction) of the light emitting element layer LDL while respectively having sloped surfaces or curved surfaces corresponding to the first and second bank patterns PW1 and PW2. Similarly, the first and second electrodes ELT1 and ELT2 and the like disposed on the third bank pattern PW3 may have shapes corresponding to the shape of the third bank pattern PW3.

Each of the first and second electrodes ELT1 and ELT2 may include at least one conductive material. For example, each of the first and second electrodes ELT1 and ELT2 may include at least one material, among metal, such as Ag, Mg, Al, Pt, Pd, Au, Ni. Nd, Ir, Cr, Ti, and an alloy thereof, a conductive oxide, such as ITO, IZO, ZnO, and ITZO, and a conductive polymer, such as PEDOT, but is not limited thereto.

Also, each of the first and second electrodes ELT1 and ELT2 may be formed of a single layer or a plurality of layers. For example, each of the first and second electrodes ELT1 and ELT2 may include at least one reflective electrode layer. Also, each of the first and second electrodes ELT1 and ELT2 may selectively further include at least one of at least one transparent electrode layer disposed on and/or under the reflective electrode layer and at least one conductive capping layer covering the upper portion of the reflective electrode layer and/or the transparent electrode layer.

According to an embodiment, the reflective electrode layer of each of the first and second electrodes ELT1 and ELT2 may be made of a conductive material having uniform reflectivity. For example, the reflective electrode layer may include at least one of metal, such as Ag, Mg, Al, Pt, Pd, Au, Ni, Nd, Ir, Cr, and an alloy thereof, but is not limited thereto. That is, the reflective electrode layer may be made of various reflective conductive materials. When each of the first and second electrodes ELT1 and ELT2 includes a reflective electrode layer, light emitted from the opposite ends of each of the light emitting elements LD, that is, the first and second ends EP1 an EP2, may further travel in the direction in which an image is displayed (e.g., in a frontal direction). Particularly, when the first and second electrodes ELT1 and ELT2 are disposed to face the first and second ends EP1 and EP2 of the light emitting elements LD while having a sloped surface or curved surface corresponding to the shapes of the first and second bank patterns PW1 and PW2, light emitted from the first and second ends EP1 and EP2 of each of the light emitting elements LD may further travel in the third direction DR3 (that is, in the frontal direction of the display panel PNL) by being reflected by the first and second electrodes ELT1 and ELT2. Accordingly, the efficiency of light emitted from the light emitting elements LD may be improved.

Also, the transparent electrode layer of each of the first and second electrodes ELT1 and ELT2 may be made of various transparent electrode materials. For example, the transparent electrode layer may include ITO, IZO, or ITZO, but is not limited thereto. In an embodiment, each of the first and second electrodes ELT1 and ELT2 may be formed of three layers having a stack structure of ITO/Ag/ITO. As described, when the first and second electrodes ELT1 and ELT2 are formed of a plurality of layers including at least two layers, a voltage drop by a signal delay (RC delay) may be minimized. Accordingly, a desired voltage may be effectively transmitted to the light emitting elements LD.

Additionally, when each of the first and second electrodes ELT1 and ELT2 includes a conductive capping layer configured to cover the reflective electrode layer and/or the transparent electrode layer, the reflective electrode layer or the like of the first and second electrodes ELT1 and ELT2 may be prevented from being damaged due to a defect caused in the process of manufacturing a pixel PXL, or the like. However, the conductive capping layer may be selectively included in the first and second electrodes ELT1 and ELT2, and may be omitted according to an embodiment. Also, the conductive capping layer may be regarded as a component of each of the first and second electrodes ELT1 and ELT2, or may be regarded as a separate component disposed on the first and second electrodes ELT1 and ELT2.

The first insulating layer INS1 may be disposed on portions of the first and second electrodes ELT1 and ELT2. For example, the first insulating layer INS1 may be formed to cover portions of the first and second electrodes ELT1 and ELT2, and may include an opening that exposes other portions of the first and second electrodes ELT1 and ELT2.

In an embodiment, the first insulating layer INS1 may be formed to fully cover the first and second electrodes ELT1 and ELT2 at first. After the light emitting elements LD are supplied to and aligned on the first insulating layer INS1 between the first and second electrodes ELT1 and ELT2, the first insulating layer INS1 may be partially opened so as to expose the first and second electrodes ELT1 and ELT2 in predetermined first and second contact portions, as illustrated in FIG. 8a. Alternatively, after the supply and alignment of the light emitting elements LD are completed, the first insulating layer INS1 may be patterned in the form of individual patterns locally disposed under the light emitting elements LD.

That is, the first insulating layer INS1 is interposed between the first and second electrodes ELT1 and ELT2 and the light emitting elements LD, and may expose at least a portion of each of the first and second electrodes ELT1 and ELT2. The first insulating layer INS1 is formed to cover the first and second electrodes ELT1 and ELT2 after the first and second electrodes ELT1 and ELT2 are formed, thereby preventing the first and the second electrodes ELT1 and ELT2 from being damaged or preventing metal from being extracted in the following process. Also, the first insulating layer INS1 may stably support the respective light emitting elements LD. According to an embodiment, the first insulating layer INS1 may be omitted.

In the emission area EMA in which the first insulating layer INS1 is formed, the light emitting elements LD may be supplied and aligned. For example, the light emitting elements LD are supplied to the emission area EMA through an inkjet method or the like, and the light emitting elements LD may be aligned between the first and second electrodes ELT1 and ELT2 by predetermined alignment voltages (or alignment signals) applied to the first and second electrodes ELT1 and ELT2. In order to align the light emitting elements LD, a reference voltage (e.g., a ground voltage) may be applied to the first electrode ELT1, and an alternating current voltage (or an alignment voltage) may be applied to the second electrode ELT2. In this case, an electric field is formed between the first and second electrodes ELT1 and ELT2, whereby the light emitting elements LD may be self-aligned between the first and second electrodes ELT1 and ELT2 in the emission area EMA.

The second insulating layer INS2 is disposed on the light emitting elements LD, particularly, the light emitting elements LD aligned between the first and second electrodes ELT1 and ELT2, thereby exposing the first and second ends EP1 and EP2 of the light emitting elements LD. For example, the second insulating layer INS2 may be partially disposed on only portions of the light emitting elements LD, without covering the first and second ends EP1 and EP2 of the light emitting elements LD. The second insulating layer INS2 may be formed as an independent pattern on each emission area EMA, but is not limited thereto. Also, as illustrated in FIG. 8A, when a space is present between the first insulating layer INS1 and the light emitting elements LD before the second insulating layer INS2 is formed, the space may be filled with the second insulating layer INS2. Accordingly, the light emitting elements LD may be more stably supported.

The first and second contact electrodes CNE1 and CNE2 may be disposed on the first and second electrodes ELT1 and ELT2 and the first and second ends EP1 and EP2 of the light emitting elements LD. In an embodiment, the first and second contact electrodes CNE1 and CNE2 may be disposed on the same layer, as illustrated in FIG. 8A. In this case, the first and second contact electrodes CNE1 and CNE2 may be formed using the same conductive material in the same process, but are not limited thereto.

The first and second contact electrodes CNE1 and CNE2 may electrically couple the first and second ends EP1 and EP2 of the light emitting elements LD to the first and second electrodes ELT1 and ELT2, respectively.

For example, the first contact electrode CNE1 may be disposed on the first electrode ELT1 so as to come into contact with the first electrode ELT1. For example, the first contact electrode CNE1 may be disposed on a portion of the first electrode ELT1 (e.g., the first contact portion), which is not covered by the first insulating layer INS1, so as to come into contact with the first electrode ELT1. Also, in order that it comes into contact with at least one light emitting element LD, e.g., the first ends EP1 of the plurality of light emitting elements LD, adjacent to the first electrode ELT1, the first contact electrode CNE1 may be disposed on the first ends EP1. That is, the first contact electrode CNE1 may be disposed to cover the first ends EP1 of the light emitting elements LD and at least a portion of the first electrode ELT1 corresponding thereto. Accordingly, the first ends EP1 of the light emitting elements LD may be electrically coupled to the first electrode ELT1.

Similarly, the second contact electrode CNE2 may be disposed on the second electrode ELT2 so as to come into contact with the second electrode ELT2. For example, the second contact electrode CNE2 may be disposed on a portion of the second electrode ELT2 (e.g., the second contact portion CNT2), which is not covered by the first insulating layer INS1, so as to come into contact with the second electrode ELT2. Also, in order that it comes into contact with at least one light emitting element LD, e.g., the second ends EP2 of the plurality of light emitting elements LD, adjacent to the second electrode ELT2, the second contact electrode CNE2 may be disposed on the second ends EP2. That is, the second contact electrode CNE2 may be disposed to cover the second ends EP2 of the light emitting elements LD and at least a portion of the second electrode ELT2 corresponding thereto. Accordingly, the second ends EP2 of the light emitting elements LD may be electrically coupled to the second electrode ELT2.

The third insulating layer INS3 may be formed and/or disposed over one surface of the first substrate SUB1, on which the first and second bank patterns PW1 and PW2, the first and second electrodes ELT1 and ELT2, the light emitting elements LD, and the first and second contact electrodes CNE1 and CNE2 are formed, so as to cover the first and second bank patterns PW1 and PW2, the first and second electrodes ELT1 and ELT2, the light emitting elements LD, and the first and second contact electrodes CNE1 and CNE2. The third insulating layer INS3 may include a thin-film encapsulation layer including at least one layer of an inorganic film and/or an organic film, but is not limited thereto. Also, according to an embodiment, at least one overcoat layer that is not illustrated may be further disposed on the third insulating layer INS3.

According to an embodiment, each of the first to third insulating layers INS1, INS2 and INS3 may be formed of a single layer or a plurality of layers, and may include at least one inorganic insulating material and/or organic insulating material. For example, each of the first to third insulating layers INS1, INS2 and INS3 may include currently known various types of organic/inorganic insulating materials as well as SiNx, and the material forming each of the first to third insulating layers INS1, INS2 and INS3 is not specifically limited. Also, the first to third insulating layers INS1, INS2 and INS3 may include different insulating materials, or at least some of the first to third insulating layers INS1, INS2 and INS3 may include the same insulating materials.

In embodiments, the first and second contact electrodes CNE1 and CNE2 may be disposed on different layers.

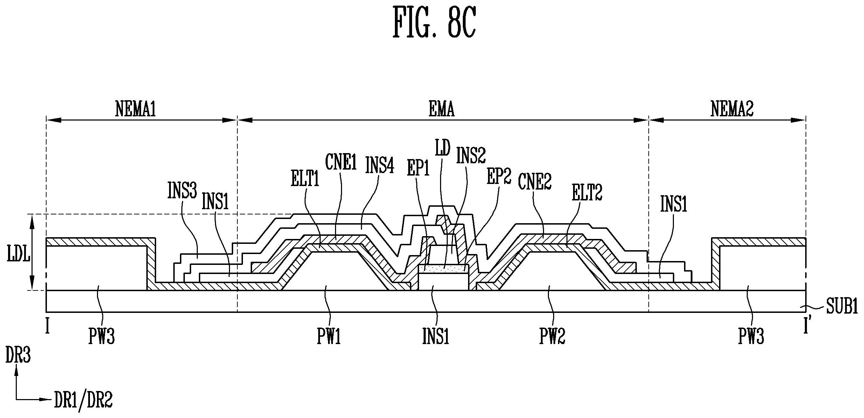

Referring to FIG. 8c, the first contact electrode CNE1 may be disposed in the sub-pixel area SPA in which the second insulating layer INS2 is disposed. According to an embodiment, the first contact electrode CNE1 may be disposed on the first electrode ELT1 so as to come into contact with a portion of the first electrode ELT1 disposed in the corresponding sub-pixel area SPA. Also, the first contact electrode CNE1 may be disposed on the first end EP1 of at least one light emitting element LD disposed in the corresponding sub-pixel area SPA so as to come into contact with the first end EP1. By the first contact electrode CNE1, the first end EP1 of at least one light emitting element LD disposed in the sub-pixel area SPA may be electrically coupled to the first electrode ELT1 disposed in the corresponding sub-pixel area SPA.

A fourth insulating layer INS4 may be disposed in the sub-pixel area SPA in which the first contact electrode CNE1 is disposed. According to an embodiment, the fourth insulating layer INS4 may cover the second insulating layer INS2 and the first contact electrode CNE1 disposed in the corresponding sub-pixel area SPA.

According to an embodiment, similar to the first to third insulating layers INS1, INS2 and INS3, the fourth insulating layer INS4 may be formed of a single layer or a plurality of layers, and may include at least one inorganic insulating material and/or organic insulating material. For example, the fourth insulating layer INS4 may include currently known various types of organic/inorganic insulating materials as well as SiNx. Also, the fourth insulating layer INS4 may include an insulating material different from that of the first to third insulating layers INS1, INS2 and INS3, or may include the same insulating material as at least some of the first to third insulating layers INS1, INS2 and INS3.

The second contact electrode CNE2 may be disposed in each sub-pixel area SPA in which the fourth insulating layer INS4 is disposed. For example, the fourth insulating layer INS4 may have a portion disposed between the first contact electrode CNE1 and the second contact electrode CNE2 to insulate the first contact electrode CNE1 from the second contact electrode CNE2. According to an embodiment, the second contact electrode CNE2 may be disposed on the second electrode ELT2 so as to come into contact with a portion of the second electrode ELT2 disposed in the corresponding sub-pixel area SPA. Also, the second contact electrode CNE2 may be disposed on the second end EP2 of at least one light emitting element LD disposed in the corresponding sub-pixel area SPA so as to come into contact with the second end EP2. By the second contact electrode CNE2, the second end EP2 of at least one light emitting element LD disposed in each sub-pixel area SPA may be electrically coupled to the second electrode ELT2 disposed in the corresponding sub-pixel area SPA.

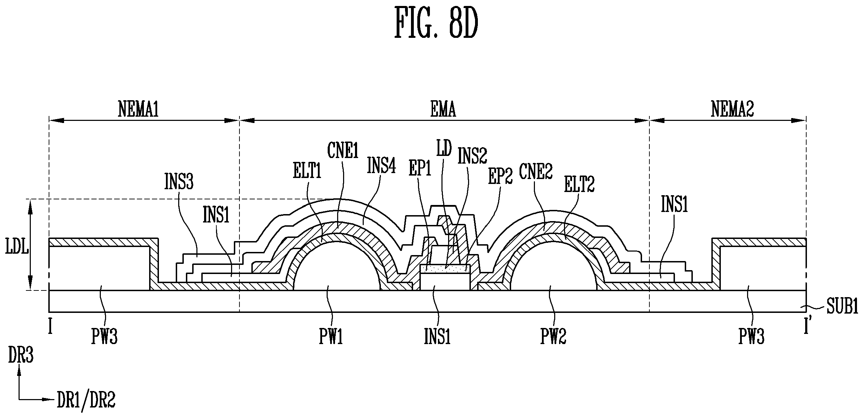

According to an embodiment, the first and second bank patterns PW1 and PW2 may have various shapes. For example, the first and second bank patterns PW1 and PW2 may have a cross-sectional shape of a trapezoid, the width of which decreases as being closer to the top thereof, as illustrated in FIG. 8c. In another example, the first and second bank patterns PW1 and PW2 may have a cross-section of a semi-circle or a semi-ellipse, the width of which decreases as being closer to the top thereof, as illustrated in FIG. 8d.

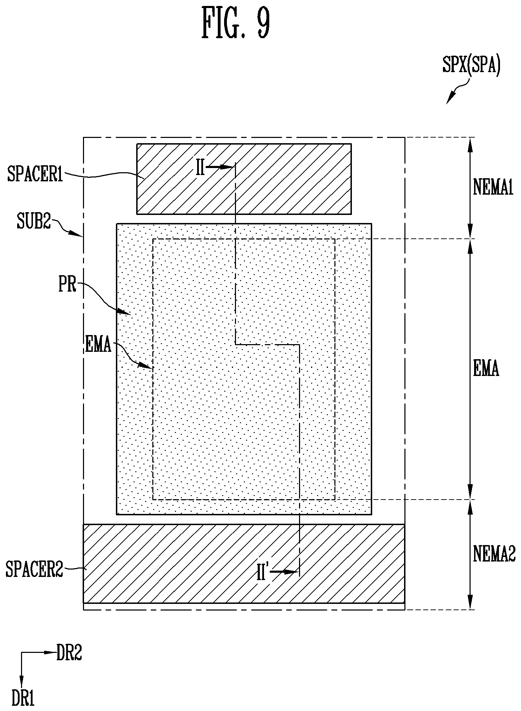

FIG. 9 is a plan view illustrating an example of the second panel included in the display device of FIG. 6. In FIG. 9, the structure of a sub-pixel SPX is illustrated with focus on a pixel circuit layer PCL corresponding to the sub-pixel SPX (e.g., the first sub-pixel SPX1) illustrated in FIG. 7.

Referring to FIG. 9, a sub-pixel SPX (or a pixel circuit layer PCL) may include first and second conductive layers SPACER1 and SPACER2 (or first and second conductive patterns), respectively disposed in first and second non-emission areas NEMA1 and NEMA2 in the sub-pixel area SPA of a second substrate SUB2, and a transmissive component PR (or a light-transmissive component, an opening) disposed in an emission area EMA.

The transmissive component PR is disposed so as to correspond to the emission area EMA of the light emitting element layer LDL and has an area equal to or greater than the area occupied by the emission area EMA in the sub-pixel area SPA, and for example, the transmissive component PR may cover the emission area EMA.

The first conductive layer SPACER1 (or the first conductive pattern) may be formed so as to correspond to the first connection electrode CONT1 described with reference to FIG. 7, and may have substantially the same area as the area of the first connection electrode CONT1 (or the area of the third bank pattern PW3 in the first non-emission area NEMA1). The first conductive layer SPACER1 (and the second conductive layer SPACER2) may function as a spacer configured to space the light emitting element layer LDL a fixed distance apart from the pixel circuit layer PCL (e.g., the pixel circuit layer PCL excluding the first and second conductive layers SPACER1 and SPACER2) or to support the light emitting element layer LDL.

Similarly, the second conductive layer SPACER2 (or the second conductive pattern) may be formed so as to correspond to the second connection electrode CONT2 described with reference to FIG. 7, and may have substantially the same area as the area of the second connection electrode CONT2 (or the area of the third bank pattern PW3 in the second non-emission area NEMA2). The second conductive layer SPACER2 may be disposed on the same layer as the first conductive layer SPACER1.

In embodiments, the second conductive layer SPACER2 may extend to an adjacent sub-pixel area (e.g., to the second and third sub-pixels SPX2 and SPX3 based on the first sub-pixel SPX1 of FIG. 4), and may also extend to the non-display area (NDA, cf. FIG. 4).

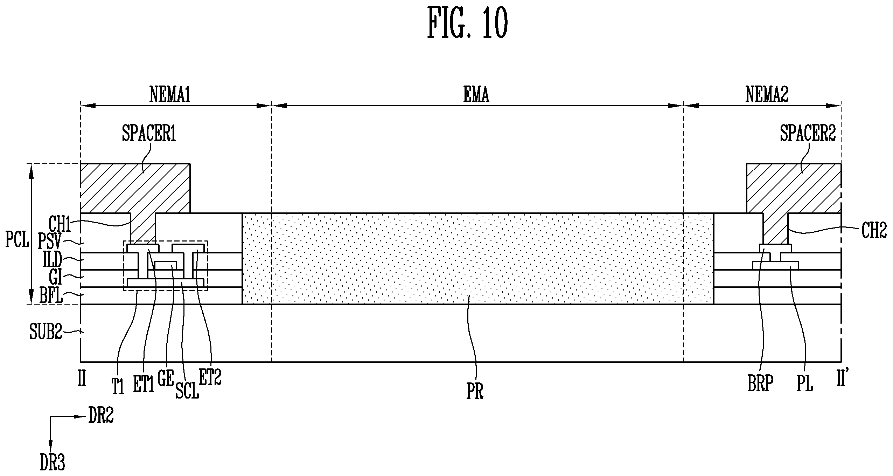

FIG. 10 is a sectional view illustrating an example of the second panel taken along the line II-II' of FIG. 9. In FIG. 10, the cross-section of the second panel corresponding to the cross-section of the first panel of FIG. 8a is illustrated. That is, the line II-II' illustrated in FIG. 9 may match the line I-I' of FIG. 7. Meanwhile, for the convenience of description, the second panel that is turned upside down is illustrated. As to be described later, the second panel may be manufactured as illustrated in FIG. 10 at first in the manufacturing process, after which the second panel that is overturned such that the locations of the top and bottom surfaces thereof are switched may be bonded to first panel (e.g., the first panel of FIG. 8a).

A pixel circuit layer PCL may be disposed on one surface of a second substrate SUB2. According to an embodiment, the pixel circuit layer PCL may be formed in the entire display area DA of a display panel PNL.

According to an embodiment, the pixel circuit layer PCL may include a plurality of circuit elements disposed in the non-emission areas NEMA1 and NEMA2. For example, the pixel circuit layer PCL may include a plurality of circuit elements forming the pixel circuit PXC of a sub-pixel SPX by being formed in the non-emission areas NEMA1 and NEMA2. For example, the pixel circuit layer PCL may include a plurality of transistors disposed in the first non-emission area NEMA1, e.g., the first transistor T1 described with reference to FIG. 5a and FIG. 5b. Also, although not illustrated in FIG. 10, the pixel circuit layer PCL may include a storage capacitor Cst disposed in the non-emission areas NEMA1 and NEMA2, various signal lines coupled to the pixel circuit PXC (e.g., the scan line Si and the data line Dj described with reference to FIG. 5a and FIG. 5b), and various power lines coupled to the pixel circuit PXC and/or light emitting elements LD (e.g., a first power line PL1 and a second power line PL2 respectively transmitting a voltage of first power supply VDD and a voltage of second power supply VSS described with reference to FIG. 5a and FIG. 5b).

According to an embodiment, the plurality of transistors provided in the pixel circuit PXC may have cross-sectional structures that are substantially identical or similar to that of the first transistor T1. However, the present disclosure is not limited thereto, and in another embodiment, at least some of the plurality of transistors may have different types and/or structures.

According to an embodiment, the pixel circuit layer PCL may include a transmissive component PR formed in the emission area EMA. The transmissive component PR may transmit at least some of light emitted from the light emitting element LD of the light emitting element layer LDL described with reference to FIG. 8a.

In embodiments, the transmissive component PR may include, for example, resin such as polyethylene terephthalate (PET), polacrylate, polyimide (PI), polycarbonate (PC), or the like, as a transparent light-transmissive organic material.

In an embodiment, the transmissive component PR may include a color filter material that transmits or blocks only light having a specific wavelength. For example, the transmissive component PR of one (e.g., the first sub-pixel SPX1) of sub-pixels SPX adjacent to each other (e.g., the first to third sub-pixels SPX1, SPX2 and SPX3, cf. FIG. 4) may include a red color filter material (or, a red-transmissive material), which transmits only red light, the transmissive component PR of another one (e.g., the second sub-pixel SPX2) may include a green color filter material (or a green-transmissive material), which transmits only green light, and the transmissive component PR of the other one (e.g., the third sub-pixel SPX3) may include a blue color filter material (or a blue-transmissive material), which transmits only blue light.

In an embodiment, the transmissive component PR may include a quantum dot. The quantum dot may convert light having a specific wavelength into light having a different wavelength, may be configured with a core, a shell, and ligands, and may be included in a diffused form in the transparent resin or the like of the transmissive component PR. For example, when the light emitting elements LD of the first panel emit blue light, the transmissive component PR of one (e.g., the first sub-pixel SPX1) of the sub-pixels SPX adjacent to each other (e.g., the first to third sub-pixels SPX1, SPX2 and SPX3, cf. FIG. 4) may include a red quantum dot configured to convert blue light into red right, the transmissive component PR of another one (e.g., the second sub-pixel SPX2) may include a green quantum dot configured to convert blue light into green light, and the transmissive component PR of the other one (e.g., the third sub-pixel SPX3) may not include a quantum dot.

The pixel circuit layer PCL may include a plurality of insulating layers disposed in the non-emission areas NEMA1 and NEMA2. For example, the pixel circuit layer PCL may include a buffer layer BFL, a gate insulating layer GI, an interlayer insulating layer ILD, and a passivation layer PSV (or a via layer) that are sequentially stacked on one surface of the second substrate SUB2 in the non-emission areas NEMA1 and NEMA2.

According to an embodiment, the buffer layer BFL may prevent impurities from diffusing into circuit elements. The buffer layer BFL may be formed of a single layer, but may be formed of a plurality of layers including at least two layers. When the buffer layer BFL is provided as a plurality of layers, the respective layers may be made of the same material or may be made of different materials. Meanwhile, according to an embodiment, the buffer layer BFL may be omitted.

According to an embodiment, the first transistor T1 may include a semiconductor layer SCL, a gate electrode GE, a first transistor electrode ET1, and a second transistor electrode ET2. Meanwhile, according to an embodiment, the first transistor T1 is illustrated as including the first transistor electrode ET1 and the second transistor electrode ET2 that are formed separately from the semiconductor layer SCL in FIG. 10, but the present disclosure is not limited thereto. For example, in another embodiment of the present disclosure, each of the first and/or second transistor electrodes ET1 and ET2 provided in at least one transistor disposed in each sub-pixel area SPA may be formed by being integrated with the semiconductor layer SCL.

The semiconductor layer SCL may be disposed on the buffer layer BFL. For example, the semiconductor layer SCL may be disposed between the second substrate SUB2 on which the buffer layer BFL is formed and the gate insulating layer GI. The semiconductor layer SCL may include a first area coming into contact with the first transistor electrode ET1, a second area coming into contact with the second transistor electrode ET2, and a channel area located between the first and second areas. According to an embodiment, one of the first and second areas is a source area, and the other one may be a drain area.

According to an embodiment, the semiconductor layer SCL may be a semiconductor pattern formed of polysilicon, amorphous silicon, an oxide semiconductor, or the like. Also, the channel area of the semiconductor layer SCL may be an intrinsic semiconductor as a semiconductor pattern that is not doped with impurities, and the first and second areas of the semiconductor layer SCL may be respective semiconductor patterns doped with predetermined impurities.

The gate electrode GE may be disposed on the semiconductor layer SCL with the gate insulating layer GI interposed therebetween. For example, the gate electrode GE may be disposed between the gate insulating layer GI and the interlayer insulating layer ILD while overlapping at least a portion of the semiconductor layer SCL.

The first and second transistor electrodes ET1 and ET2 may be disposed on the semiconductor layer SCL and the gate electrode GE while interposing at least one interlayer insulating layer ILD therebetween. For example, the first and second transistor electrodes ET1 and ET2 may be disposed between the interlayer insulating layer ILD and the passivation layer PSV. The first and second transistor electrodes ET1 and ET2 may be electrically coupled to the semiconductor layer SCL. For example, the first and second transistor electrodes ET1 and ET2 may be respectively coupled to the first area and second area of the semiconductor layer SCL through corresponding contact holes passing through the gate insulating layer GI and the interlayer insulating layer ILD.

In embodiments, the first conductive layer SPACER1 may be disposed on the passivation layer PSV in the first non-emission area NEMA1. The first conductive layer SPACER1 may be electrically coupled to one (e.g., the first transistor electrode ET1) of the first and second transistor electrodes ET1 and ET2 through a first contact hole CH1 passing through the passivation layer PSV.

According to an embodiment, at least one signal line and/or power line coupled to a sub-pixel SPX may be disposed on the same layer as one electrode of the circuit elements forming the pixel circuit PXC.

For example, in the second non-emission area NEMA2, a power line PL (e.g., the second power line PL2 for supplying a voltage of the second power supply VSS) may be disposed on the same layer as the gate electrode GE of each of the first and second transistors T1 and T2, and may be electrically coupled to the second conductive layer SPACER2 through at least one second contact hole CH2 passing through the passivation layer PSV and a bridge pattern BRP that is disposed on the same layer as the first and second transistor electrodes ET1 and ET2.

However, the structure and/or location of the power line PL or the like may be variously changed.

Each of the first and second conductive layers SPACER1 and SPACER2, the gate electrode GE, the power line PL, the first and second transistor electrodes ET1 and ET2, and the bridge pattern BRP may include at least one conductive material. For example, each of the first and second conductive layers SPACER1 and SPACER2, the gate electrode GE, the power line PL, the first and second transistor electrodes ET1 and ET2, and the bridge pattern BRP may include at least one material, among metals such as Ag, Mg, Al, Pt, Pd, Au, Ni, Nd, Ir, Cr, Ti, and an alloy thereof, a conductive oxide, such as ITO, IZO, ZnO, and ITZO, and a conductive polymer such as PEDOT, but is not limited thereto.

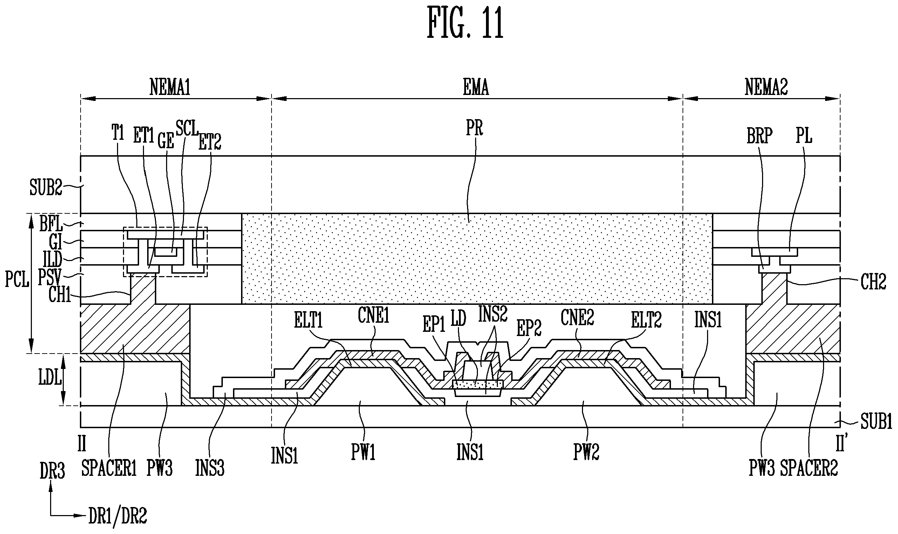

FIG. 11 is a sectional view illustrating an example of the display device of FIG. 6. In FIG. 11, as the cross-section of a display device based on a sub-pixel area SPA, the state in which the second panel of FIG. 10 is overturned (or is turned upside down) and is combined with the first panel of FIG. 8a is illustrated.

Referring to FIG. 11, a first substrate SUB1, a light emitting element layer LDL, a pixel circuit layer PCL, and a second substrate SUB2 may be sequentially stacked along the third direction DR3. That is, the light emitting element layer LDL may be disposed on the first substrate SUB1, the pixel circuit layer PCL may be disposed on the light emitting element layer LDL, and the second substrate SUB2 may be disposed on the pixel circuit layer PCL.

The first substrate SUB1 and the light emitting element layer LDL are substantially the same as the first substrate SUB1 and the light emitting element layer LDL described with reference to FIG. 8a, and thus a redundant description will not be repeated.

In the first non-emission area NEMA1, a first conductive layer SPACER1 may be disposed on a first electrode ELT1. The first conductive layer SPACER1 may have a size (or an area) corresponding to a portion of the first electrode ELT1 protruding in the third direction DR3 (that is, an upward direction) by a third bank pattern PW3, and for example, the size of the first conductive layer SPACER1 may be substantially the same as the size of the portion of the first electrode ELT1 protruding by the third bank pattern PW3.

In embodiments, the thickness of the first conductive layer SPACER1 is greater than the average thickness of the third insulating layer INS3 (and may be greater than the average thickness of the overcoat layer) of the light emitting element layer LDL. That is, the first conductive layer SPACER1 has a sufficient thickness such that the third insulating layer INS3 and components thereunder are not pressurized by a transmissive component PR in the emission area EMA. For example, the first conductive layer SPACER1 may have a thickness equal to or greater than 2 µm.

In embodiments, the first conductive layer SPACER1 may not overlap the third insulating layer INS3. That is, the third insulating layer INS3 may expose a protruding portion of the first electrode ELT1 (e.g., the first connection electrode CONT1 described with reference to FIG. 7) in the first non-emission area NEMA1, and the first conductive layer SPACER1 may come into direct contact with the protruding portion of the first electrode ELT1 or may be combined with the same. For example, the first conductive layer SPACER1 may be combined with the first electrode ELT1 through ultrasonic bonding, an anisotropic conductive film, or the like.

A passivation layer PSV, first and second transistor electrodes ET1 and ET2, an interlayer insulating layer ILD, a gate electrode GE, a gate insulating layer GI, a semiconductor layer SCL (or a semiconductor pattern), and a buffer layer BFL may be sequentially disposed on the first conductive layer SPACER1. As described above, the first and second transistor electrodes ET1 and ET2, the gate electrode GE, and the semiconductor layer SCL may form a first transistor T1. The first conductive layer SPACER1 may come into contact with the first transistor T1 (or the first transistor electrode ET1) through a first contact hole CH1 (or a first via hole) passing through the passivation layer PSV (or a via layer).

Similar to the first non-emission area NEMA1, a second conductive layer SPACER2 may be disposed on a second electrode ELT2 in the second non-emission area NEMA2. The second conductive layer SPACER2 may have a size (or an area) corresponding to a portion of the second electrode ELT2 protruding in the third direction DR3 (that is, the upward direction) by the third bank pattern PW3, and for example, the size of the second conductive layer SPACER2 may be substantially the same as the size of the portion of the second electrode ELT2 protruding by the third bank pattern PW3.

The thickness of the second conductive layer SPACER2 may be substantially the same as the thickness of the first conductive layer SPACER1. The second conductive layer SPACER2 may not overlap the third insulating layer INS3. That is, the third insulating layer INS3 may expose a protruding portion of the second electrode ELT2 (e.g., the second connection electrode CONT2 described with reference to FIG. 7) in the second non-emission area NEMA2, and the second conductive layer SPACER2 may come into direct contact with the protruding portion of the second electrode ELT2 or may be combined with the same.

A passivation layer PSV, a bridge pattern BRP, an interlayer insulating layer ILD, a power line PL, a gate insulating layer GI, and a buffer layer BFL may be sequentially disposed on the second conductive layer SPACER2. The second conductive layer SPACER2 may be coupled to the bridge pattern BRP and the power line PL through a second contact hole CH2 (or a second via hole) passing through the passivation layer PSV (or a via layer).

In the emission area EMA, the transmissive component PR of the pixel circuit layer PCL may be disposed on the third insulating layer INS3. The transmissive component PR may be disposed to be spaced apart from the third insulating layer INS3, but is not limited thereto. The transmissive component PR transmits light, which is emitted from a light emitting element LD commonly in the third direction DR3, and accordingly, an image may be displayed through one surface of the second substrate SUB2 (that is, the surface of the display device in the third direction DR3). That is, the display device may emit light from the back side based on the pixel circuit layer PCL.

Meanwhile, the thickness of the transmissive component PR is illustrated as being the same as the total thickness of the passivation layer PSV, the interlayer insulating layer ILD, the gate insulating layer GI, and the buffer layer BFL in FIG. 11, but is not limited thereto. For example, the thickness of the transmissive component PR may be less than the total thickness of the passivation layer PSV, the interlayer insulating layer ILD, the gate insulating layer GI, and the buffer layer BFL. In another example, the thickness of the transmissive component PR may be greater than the total thickness of the passivation layer PSV, the interlayer insulating layer ILD, the gate insulating layer GI, and the buffer layer BFL, and the top surface of the transmissive component PR may not be flat.

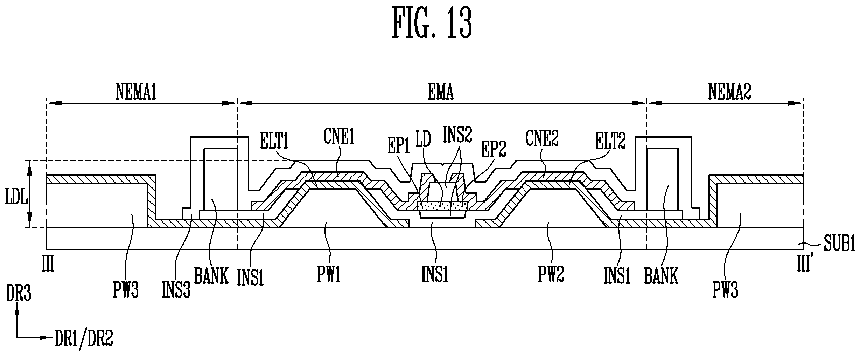

FIG. 12 is a plan view illustrating another example of the first panel included in the display device of FIG. 6. In FIG. 12, a sub-pixel SPX corresponding to the sub-pixel SPX illustrated in FIG. 7 is illustrated. FIG. 13 is a sectional view illustrating another example of the first panel taken along the line III-III' of FIG. 12. In FIG. 13, a sub-pixel SPX corresponding to the sub-pixel SPX illustrated in FIG. 8a is illustrated.

Referring to FIG. 7, FIG. 8a, FIG. 12 and FIG. 13, the sub-pixel SPX (or the first panel) of FIG. 12 is different from the sub-pixel SPX of FIG. 7 in that it further includes a bank BANK. The sub-pixel SPX of FIG. 12 is substantially the same as the sub-pixel SPX of FIG. 7, except for the bank BANK, and thus a redundant description will not be repeated.

The bank BANK is disposed along the edge of an emission area EMA, and may enclose the emission area EMA. For example, in order to enclose the emission area EMA of a sub-pixel SPX, the bank BANK may be disposed between the sub-pixel SPX and another sub-pixel SPX (or between other sub-pixels SPX). That is, the emission area EMA may be defined by the bank BANK, or the bank BANK may configure a pixel definition layer for partitioning the emission area EMA of a sub-pixel SPX.

In embodiments, the bank BANK may not overlap first and second conductive layers SPACER1 and SPACER2. For example, the bank BANK may be disposed between the first conductive layer SPACER1 and the emission area EMA, and may also be disposed between the second conductive layer SPACER2 and the emission area EMA.

According to an embodiment, at the step of supplying light emitting elements LD to each emission area EMA, the bank BANK may prevent the solution with which the light emitting elements LD are mixed from flowing in the emission area EMA of an adjacent sub-pixel SPX or may function as a dam structure for performing control such that a fixed amount of solution is supplied to each emission area EMA.

According to an embodiment, the bank BANK may be formed so as to prevent light emitted from each emission area EMA from leaking into the adjacent emission area EMA and from generating light interference. To this end, the bank BANK may be formed to prevent light emitted from the light emitting elements LD of each sub-pixel SPX from penetrating the bank BANK.

Referring to FIG. 13, the bank BANK may be disposed on a first substrate SUB1. For example, the bank BANK may be interposed between a first insulating layer INS1 and a third insulating layer INS3.

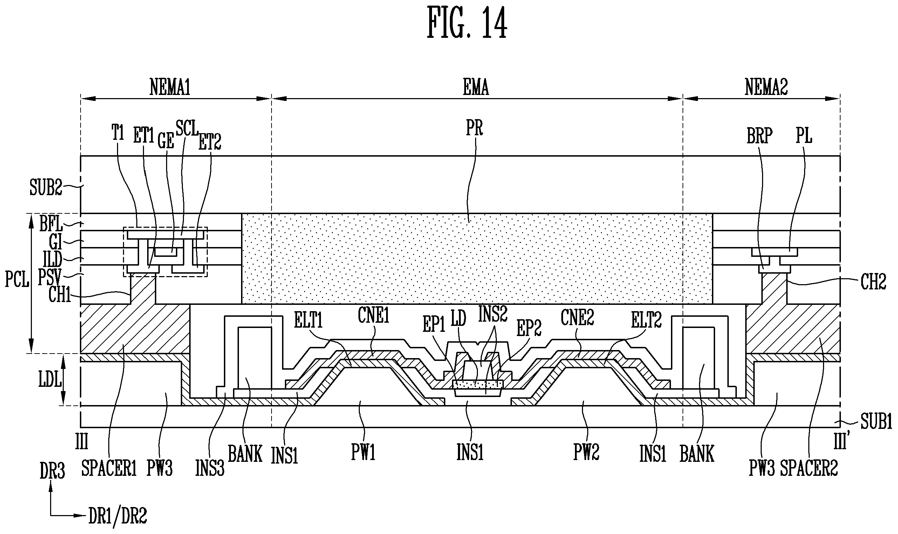

FIG. 14 is a sectional view illustrating another example of the display device of FIG. 6. In FIG. 14, as the display device corresponding to FIG. 11, the state in which the second panel of FIG. 10 is overturned (or is turned upside down) and combined with the first panel of FIG. 13 is illustrated.

Referring to FIG. 11 and FIG. 14, the display device of FIG. 14 is different from the display device of FIG. 11 in that it further includes a bank BANK. The display device of FIG. 14 is substantially the same as the display device of FIG. 11, except for the bank BANK, and thus a redundant description will not be repeated.

According to an embodiment, the total thickness of a first conductive layer SPACER1 (or a second conductive layer SPACER2) and a third bank pattern PW3 may be greater than the thickness of the bank BANK. For example, when the thickness of the bank BANK is equal to or greater than 2.5 µm and when the thickness of the third bank pattern PW3 is 2 µm, the thickness of the first conductive layer SPACER1 may be equal to or greater than 1 µm.

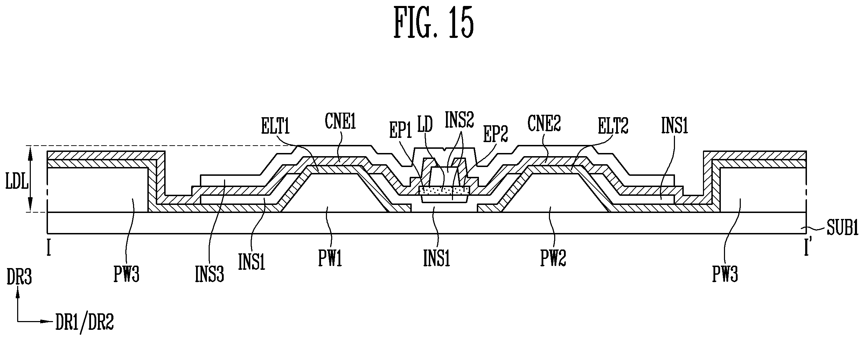

FIG. 15 is a sectional view illustrating a further example of the first panel taken along the line I-I' of FIG. 7.

Referring to FIG. 7, FIG. 8a, and FIG. 15, the first panel of FIG. 15 may be substantially the same as the first panel of FIG. 8a, except for the first and second contact electrodes CNE1 and CNE2. Therefore, a redundant description will not be repeated.

The first and second contact electrodes CNE1 and CNE2 may be disposed on first and second electrodes ELT1 and ELT2, and may overlap a third bank pattern PW3 (or the first and second connection electrodes CONT1 and CONT2 described with reference to FIG. 7).

For example, the first contact electrode CNE1 may be disposed on the first electrode ELT1 in the first non-emission area NEMA1 and may overlap the third bank pattern PW3 in the third direction DR3. That is, the first contact electrode CNE1 may cover the first electrode ELT1 in the first non-emission area NEMA1, and may protrude in the third direction DR3 by the third bank pattern PW3 in the first non-emission area NEMA1. Similarly, the second contact electrode CNE2 may be disposed on the second electrode ELT2 in the second non-emission area NEMA2, and may overlap the third bank pattern PW3 in the third direction DR3. That is, the second contact electrode CNE2 may cover the second electrode ELT2 in the second non-emission area NEMA2, and may protrude in the third direction DR3 by the third bank pattern PW3 in the second non-emission area NEMA2.

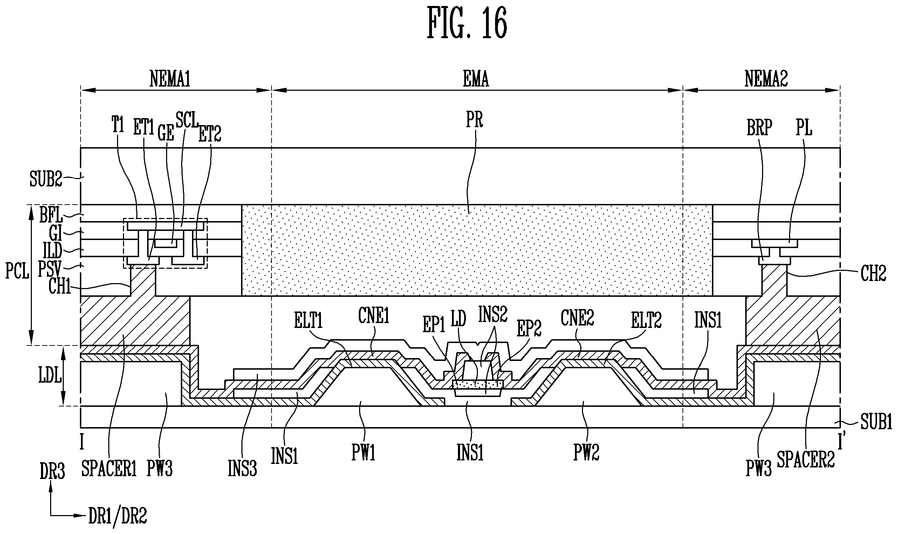

FIG. 16 is a sectional view illustrating a further example of the display device of FIG. 6. In FIG. 16, as the cross-section of a display device based on a sub-pixel area SPA, the state in which the second panel of FIG. 10 is overturned (or is turned upside down) and is combined with the first panel of FIG. 15 is illustrated.

Referring to FIG. 11 and FIG. 16, the display device of FIG. 16 is substantially the same as the display device of FIG. 11 except for the first and second contact electrodes CNE1 and CNE2, and thus a redundant description will not be repeated.

In the first non-emission area NEMA1, a first electrode ELT1 may be disposed on a third bank pattern PW3, a first contact electrode CNE1 may be disposed on the first electrode ELT1, and a first conductive layer SPACER1 may be disposed on the first contact electrode CNE1. That is, in the first non-emission area NEMA1, the first contact electrode CNE1 may be interposed between the first electrode ELT1 and the first conductive layer SPACER1.

The first conductive layer SPACER1 has a size (or an area) corresponding to a portion of the first contact electrode CNE1 protruding in the third direction DR3 (that is, in the upward direction) by the third bank pattern PW3, and for example, the size of the first conductive layer SPACER1 may be substantially the same as the size of the first contact electrode CNE1 protruding by the third bank pattern PW3, but is not limited thereto.

The first contact electrode CNE1 may be directly coupled to the first ends EP1 of light emitting elements LD in the emission area EMA, and may be electrically coupled to the first transistor T1 of a pixel circuit layer PCL through the first conductive layer SPACER1 in the first non-emission area NEMA1. That is, the first contact electrode CNE1 may electrically couple the light emitting elements LD to the first transistor T1.

Similarly, in the second non-emission area NEMA2, a second electrode ELT2 may be disposed on the third bank pattern PW3, a second contact electrode CNE2 may be disposed on the second electrode ELT2, and a second conductive layer SPACER2 may be disposed on the second contact electrode CNE2. That is, in the second non-emission area NEMA2, the second contact electrode CNE2 may be interposed between the second electrode ELT2 and the second conductive layer SPACER2.

The second contact electrode CNE2 may be directly coupled to the second ends EP2 of the light emitting elements LD in the emission area EMA, and may be electrically coupled to the power line PL (e.g., the second power line PL2 to which a voltage of the second power supply VSS is applied) of the pixel circuit layer PCL through the second conductive layer SPACER2 and bridge pattern BRP in the second non-emission area NEMA2. That is, the second contact electrode CNE2 may electrically couple the light emitting elements LD to the power line PL.

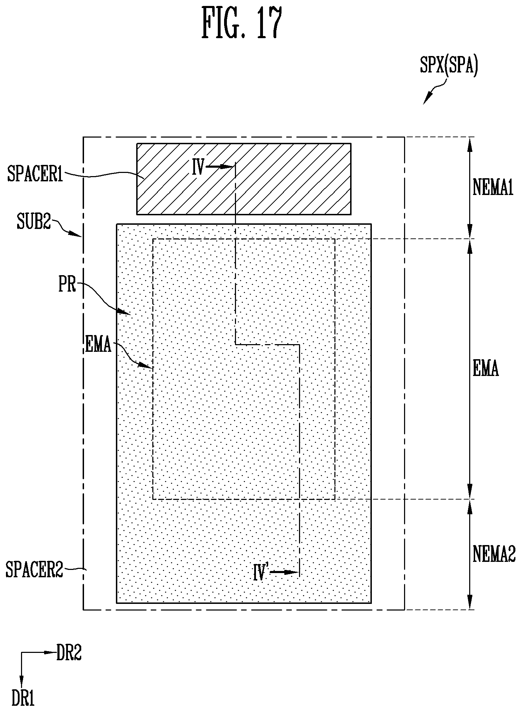

FIG. 17 is a plan view illustrating another example of the second panel included in the display device of FIG. 6. In FIG. 17, the structure of a sub-pixel SPX is illustrated based on a pixel circuit layer PCL corresponding to the sub-pixel SPX illustrated in FIG. 7 (e.g., the first sub-pixel SPX1).

First, referring to FIG. 6, FIG. 7, and FIG. 17, a sub-pixel SPX (or a pixel circuit layer PCL) may include a first conductive layer SPACER1 disposed in the first non-emission area NEMA1 of a second substrate SUB2 and a transmissive component PR disposed in the emission area EMA and the second non-emission area NEMA2.

The first conductive layer SPACER1 may be substantially identical or similar to the first conductive layer SPACER1 described with reference to FIG. 9, and the transmissive component PR may be substantially identical or similar to the transmissive component PR described with reference to FIG. 9, except for the size thereof (or the shape, the location at which it is disposed). Therefore, a redundant description will not be repeated.

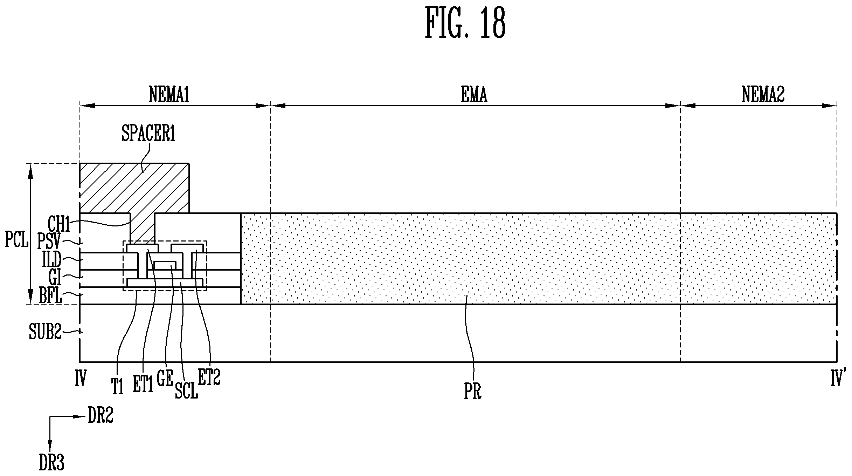

FIG. 18 is a sectional view illustrating another example of the second panel taken along the line IV-IV' of FIG. 17. In FIG. 18, the cross-section of the second panel corresponding to the cross-section of the first panel of FIG. 8a is illustrated. That is, the line IV-IV' illustrated in FIG. 18 may match the line I-I' of FIG. 7. Meanwhile, for the convenience of description, the second panel that is turned upside down is illustrated. As described above, the second panel is manufactured as illustrated in FIG. 18 in the manufacturing process, and then the second panel may be bonded to the first panel in the state in which it is overturned such that the locations of the top and bottom surfaces thereof are switched.

Referring to FIG. 10 and FIG. 18, the second panel of FIG. 18 is substantially identical or similar to the second panel of FIG. 10 except for the disposition of a transmissive component PR, and thus a redundant description will not be repeated.

A pixel circuit layer PCL may include a transmissive component PR formed in the emission area EMA and the second non-emission area NEMA2. The transmissive component PR may transmit at least some of emitted light, incident from the lower portion, to the upper portion.

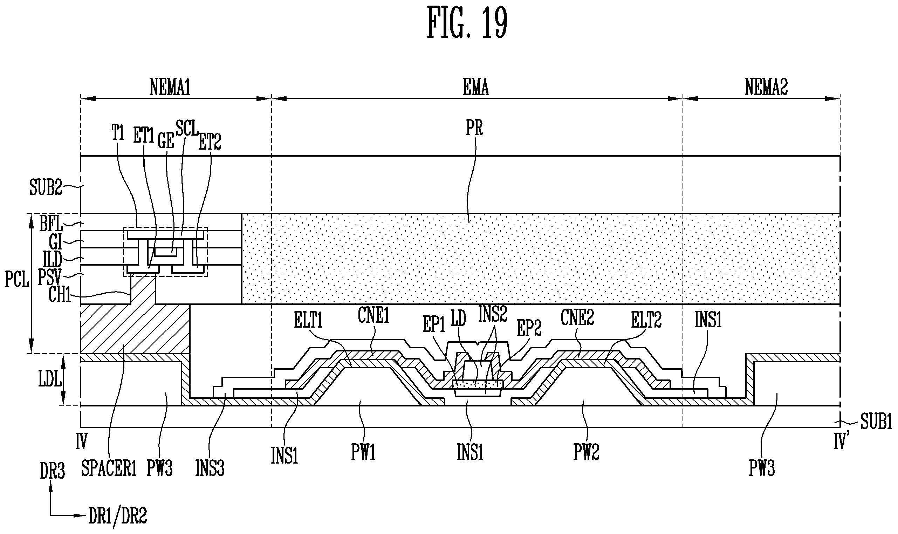

FIG. 19 is a sectional view illustrating a further example of the display device of FIG. 6. In FIG. 19, as the cross-section of a display device based on a sub-pixel area SPA, the state in which the second panel of FIG. 18 is overturned (or is turned upside down) and is combined with the first panel of FIG. 8a is illustrated.

Referring to FIG. 11 and FIG. 19, the display device of FIG. 19 is substantially identical or similar to the display device of FIG. 11 except for the stack structure in the second non-emission area NEMA2, and thus a redundant description will not be repeated.

In the second non-emission area NEMA2, a transmissive component PR may be disposed on a light emitting element layer LDL. For example, the transmissive component PR may be disposed to be spaced apart from the light emitting element layer LDL, but is not limited thereto. For example, the third insulating layer INS3 (and/or the overcoat layer) of the light emitting element layer LDL may be disposed on a second electrode ELT2 in the second non-emission area NEMA2, and may also support the transmissive component PR while coming into contact with the transmissive component PR.

Meanwhile, the second electrode ELT2 may be coupled to the power line of a pixel circuit layer PCL (e.g., the second power line PL2 to which a voltage of the second power supply VSS is applied) in the non-display area (NDA, cf. FIG. 4), rather than in the pixel area.

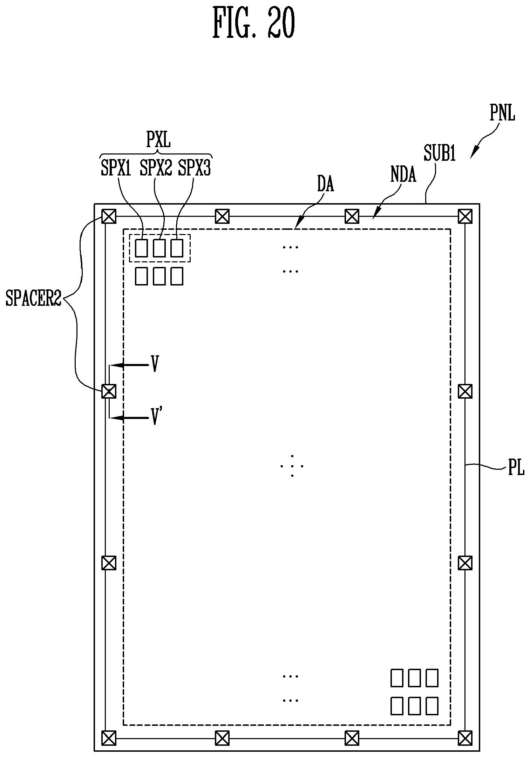

FIG. 20 may be referred to in order to explain the configuration of coupling of the second electrode ELT2 to the power line of the pixel circuit layer PCL.

FIG. 20 is a plan view illustrating a display device according to another embodiment of the present disclosure. In FIG. 20, a display panel PNL provided in the display device is briefly illustrated.

Referring to FIG. 4 and FIG. 20, the display panel PNL of FIG. 20 is substantially identical or similar to the display panel PNL of FIG. 4 except for a power line PL and a second conductive layer SPACER2. Therefore, a redundant description will not be repeated.

The display panel PNL includes sub-pixels SPX1, SPX2 and SPX3, and at least some of the sub-pixels SPX1, SPX2 and SPX3 may have the cross-sectional structure described with reference to FIG. 19.

The display panel PNL may include a power line PL and a second conductive layer SPACER2 that are formed in the non-display area NDA.

The power line PL may be disposed along the edge of the display area DA and may form a closed loop, but is not limited thereto. The power line PL may be the second power line PL2 described with reference to FIG. 5a or the first power line PL1 described with reference to FIG. 5b.

The second conductive layer SPACER2 may be repeatedly disposed at regular intervals along the edge of the display area DA, and may be electrically coupled to the power line PL.

In embodiments, the second conductive layer SPACER2 may be electrically coupled to a second electrode (ELT2, cf. FIG. 11) in the non-display area NDA.

The cross-section of the display panel PNL taken along the line V-V' of FIG. 20 may be substantially the same as the cross-section of the second non-emission area NEMA2 illustrated in FIG. 11.

As described with reference to FIG. 7, the second electrode ELT2 may extend to an adjacent sub-pixel SPX, and may further extend to the non-display area NDA. In this case, similar to the second conductive layer SPACER2 in the second non-emission area NEMA2 illustrated in FIG. 11, the second conductive layer SPACER2 illustrated in FIG. 20 may be electrically coupled to the power line PL through at least one second contact hole CH2 passing through the passivation layer PSV of the pixel circuit layer PCL. That is, the sub-pixels SPX1, SPX2 and SPX3 may be electrically coupled to the power line PL through the second electrode ELT2, extending to the non-display area NDA, and the second conductive layer SPACER2 (or the contact holes CH2 corresponding to the second conductive layer SPACER2).

As described with reference to FIGS. 17 to 20, a sub-pixel SPX may be coupled to the circuit elements of the pixel circuit layer PCL through the first conductive layer SPACER1 disposed in the first non-emission area NEMA1 of the sub-pixel area SPA, and may be electrically coupled to the power line PL through the second conductive layer SPACER2 disposed in the non-display area NDA. Because the second conductive layer SPACER2 is not disposed in the sub-pixel area SPA that has a limited area, the area of at least one of the first conductive layer SPACER1 and the transmissive component PR may be relatively increased. For example, the area of the first conductive layer SPACER1 may be increased, in which case the binding force, electric conductivity, and the like between the pixel circuit in the pixel circuit layer PCL and the first electrode ELT1 may be improved. In another example, the area of the transmissive component PR may be increased, in which case the emission area EMA is set large so as to correspond to the transmissive component PR and an increase in the number of light emitting elements LD disposed in the emission area EMA may result in improvement in the maximum luminance.

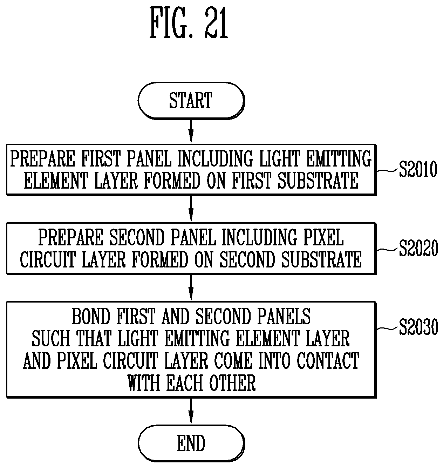

FIG. 21 is a flowchart illustrating a method of manufacturing a display device according to an embodiment of the present disclosure.

Referring to FIG. 4, FIG. 6, and FIG. 21, the method of FIG. 21 enables the display device (or the display panel PNL) of FIG. 6 to be manufactured.

In the method of FIG. 21, the first panel STR1 and the second panel STR2 illustrated in FIG. 4 may be respectively prepared at steps S2010 and S2020.

The first panel STR1 may be one of the first panels illustrated in FIGS. 8a to 8d, FIG. 13 and FIG. 15. The second panel STR2 may be one of the second panels illustrated in FIG. 10 and FIG. 18.

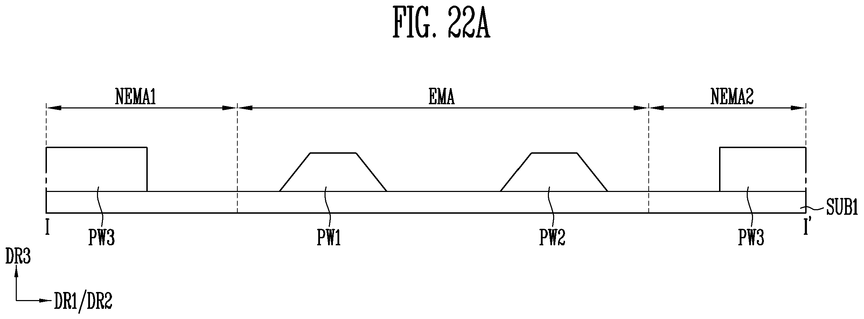

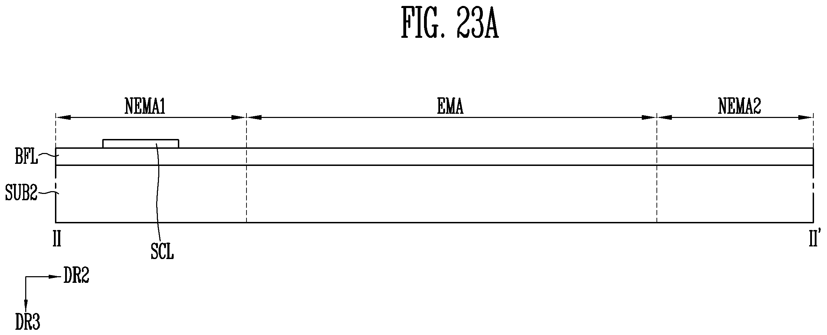

The process of preparing the first panel STR1 and the second panel STR2 will be described later with reference to FIGS. 22a to 22d and FIGS. 23a to 23g.

Then, in the method of FIG. 21, the first panel STR1 and the second panel STR2 may be bonded to each other at step S2030 such that the light emitting element layer LDL of a first substrate SUB1 and the pixel circuit layer PCL of a second substrate SUB2 come into contact with each other.

For example, in the method of FIG. 21, the second panel STR2 (e.g., the second panel STR2 of FIG. 10) is overturned or is rotated by 180 degrees such that the top and bottom surfaces thereof are switched, the second panel STR2 is aligned on the first panel STR1 such that the first conductive layer SPACER1 of the second panel STR2 faces the first electrode ELT1 of the first panel STR1 (that is, the first electrode ELT1 of the first non-emission area NEMA1) and such that the second conductive layer SPACER2 of the second panel STR2 faces the second electrode ELT2 of the first panel STR1 (that is, the second electrode ELT2 of the second non-emission area NEMA2), and then the second panel STR2 may be combined with the first panel STR1. In this case, the display device may have the cross-sectional structure of FIG. 11.

In another example, in the method of FIG. 21, the first panel STR1 is overturned and aligned on the second panel STR2, and then the first panel STR1 may be combined with the second panel STR2.

FIGS. 22a to 22d are views for explaining the process of preparing the first panel according to the method of FIG. 21.

Referring to FGS. 22a to 22d, the process of preparing the first panel STR1 having the cross-sectional structure of FIG. 8a at step S2010 in the display device manufacturing method of FIG. 21 is illustrated as an example.

In the method of FIG. 21, first to third bank patterns PW1, PW2 and PW3 may be formed on a first substrate SUB1, as illustrated in FIG. 22a.

For example, in the method of FIG. 21, a bank pattern layer for forming the first to third bank patterns PW1, PW2 and PW3 is formed on the entire first substrate SUB1, after which the first to third bank patterns PW1, PW2 and PW3 may be formed through an etching process, or the like.

As described with reference to FIG. 7 and FIG. 8a, the first and second bank patterns PW1 and PW2 may be formed such that one of the side surfaces thereof face each other on the emission area EMA of the first substrate SUB1, and the third bank pattern PW3 may be formed in first and second non-emission areas NEMA1 and NEMA2.

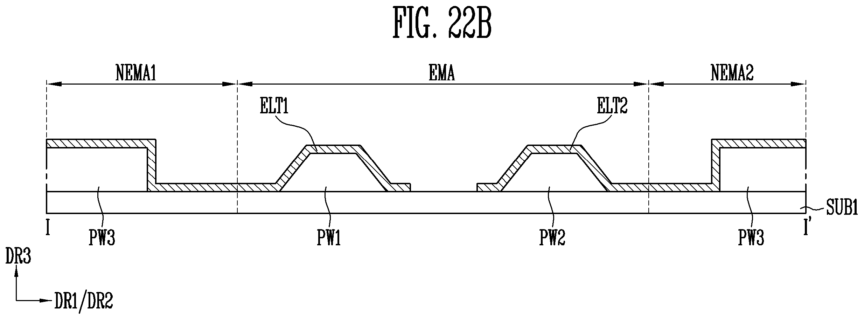

Then, in the method of FIG. 21, first and second electrodes ELT1 and ELT2 may be formed on the first substrate SUB1 and the first to third bank patterns PW1, PW2 and PW3, as illustrated in FIG. 22b.

For example, in the method of FIG. 21, a first conductive layer may be formed on the entire first substrate SUB1, and the first conductive layer may be patterned to form the first and second electrodes ELT1 and ELT2.

As described with reference to FIG. 7 and FIG. 8a, the first electrode ELT1 may be formed to cover the first bank pattern PW1 and the third bank pattern PW3 of the first non-emission area NEMA1, and the second electrode ELT2 may be formed to cover the second bank pattern PW2 and the third bank pattern PW3 of the second non-emission area NEMA2.

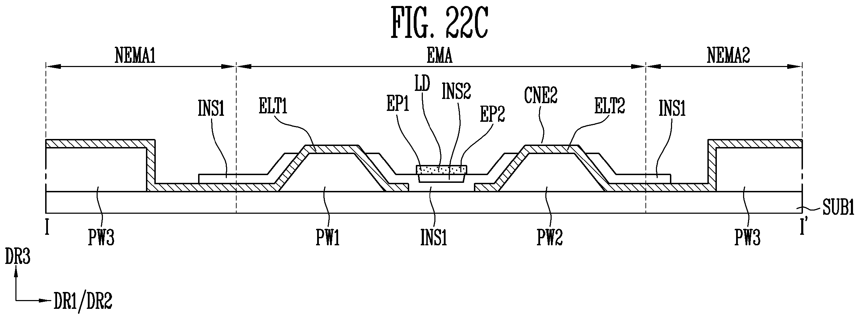

Then, in the method of FIG. 21, a first insulating layer INS1 may be formed to cover portions of the first and second electrodes ELT1 and ELT2, as illustrated in FIG. 22c. For example, in the method of FIG. 21, an insulating layer is formed on the entire first substrate SUB1, after which the first insulating layer INS1 may be formed through an etching process or the like. In embodiments, the first insulating layer INS1 may be omitted.

Then, in the method of FIG. 21, light emitting elements LD may be disposed between the first electrode ELT1 and the second electrode ELT2 in the emission area EMA.

For example, in the method of FIG. 21, the light emitting elements LD may be supplied to the emission area EMA through an inkjet method or the like, and predetermined alignment voltages (or alignment signals) may be applied between the first and second electrode ELT1 and ELT2. In this case, an electric field may be formed between the first and second electrodes ELT1 and ELT2, and the light emitting elements LD may be aligned between the first and second electrodes ELT1 and ELT2 according to the electric field.

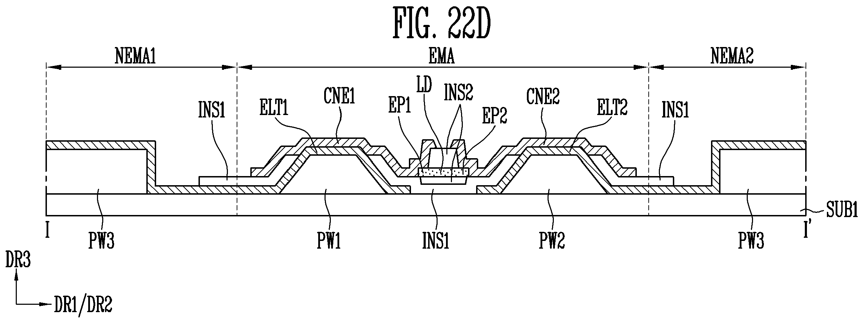

Then, in the method of FIG. 21, a second insulating layer INS2 may be formed on the light emitting elements LD such that the first and second ends EP1 and EP2 of the light emitting elements LD are exposed, as illustrated in FIG. 22d. Similar to the process of forming the first insulating layer INS1, the method of FIG. 21 enables the second insulating layer INS2 to be formed through application of an insulating material and etching. When a space is present between the first insulating layer INS1 and the light emitting elements LD, the space may be filled with the second insulating layer INS2.

Then, in the method of FIG. 21, first and second contact electrodes CNE1 and CNE2 may be formed on the first and second electrodes ELT1 and ELT2 and the first and second ends EP1 and EP2 of the light emitting elements LD.

The first and second contact electrodes CNE1 and CNE2 may be disposed on the same layer, but are not limited thereto. For example, in the method of FIG. 21, the first contact electrode CNE1 may be formed, a fourth insulating layer INS4 may be formed to cover the first contact electrode CNE1, and the second contact electrode CNE2 may be formed, as illustrated in FIG. 8c and FIG. 8d. In this case, the first and second contact electrodes CNE1 and CNE2 may be formed on different layers.

According to an embodiment, in the method of FIG. 21, the first and second contact electrodes CNE1 and CNE2 may be formed to overlap the third bank pattern PW3, as described with reference to FIG. 15.

Then, in the method of FIG. 21, a third insulating layer INS3 may be formed over one surface of the first substrate SUB1, on which the first and second bank patterns PW1 and PW2, the first and second electrodes ELT1 and ELT2, the light emitting elements LD, and the first and second contact electrodes CNE1 and CNE2 are formed, so as to cover the first and second bank patterns PW1 and PW2, the first and second electrodes ELT1 and ELT2, the light emitting elements LD, and the first and second contact electrodes CNE1 and CNE2. Accordingly, the first panel STR1 may have the cross-sectional structure of FIG. 8a.

For example, in the method of FIG. 21, the third insulating layer INS3 may be formed by forming an insulating layer on the entire first substrate SUB1 and removing a portion overlapping the third bank pattern PW3 therefrom through an etching process, or the like.

According to an embodiment, in the method of FIG. 21, at least one overcoat layer may be further formed on the third insulating layer INS3.

FIGS. 23a to 23g are views for explaining the process of preparing the second panel according to the method of FIG 21.

Referring to FIGS. 23a to 23g, the process of preparing the second panel STR2 having the cross-sectional structure of FIG. 10 at step S2020 in the display device manufacturing process of FIG. 21 is illustrated as an example.

In the method of FIG. 21, a semiconductor layer SCL may be formed on the non-emission areas NEMA1 and NEMA2 of a second substrate SUB2, as illustrated in FIG. 23a. For example, in the method of FIG. 21, the semiconductor layer SCL of the first transistor T1 described with reference to FIG. 10 may be formed in the first non-emission area NEMA1.

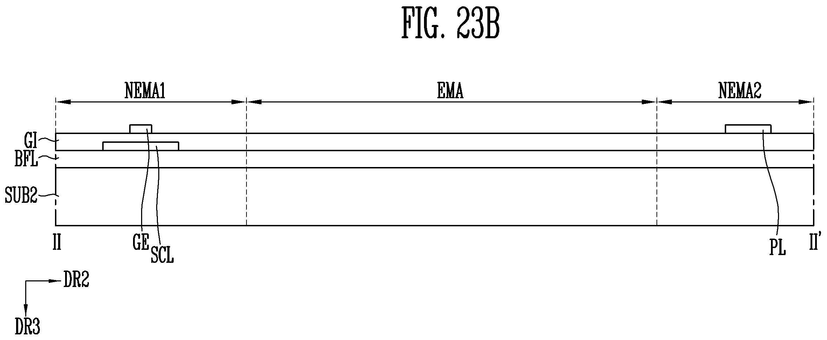

Then, in the method of FIG. 21, a gate insulating layer GI may be formed over the entire second substrate SUB2, and first conductive patterns may be formed on the gate insulating layer GI, as illustrated in FIG. 23b. Here, the first conductive patterns may include a gate electrode GE and a power line PL. For example, in the method of FIG. 21, the gate electrode GE may be formed in the first non-emission area NEMA1, and the power line PL may be formed in the second non-emission area NEMA2.

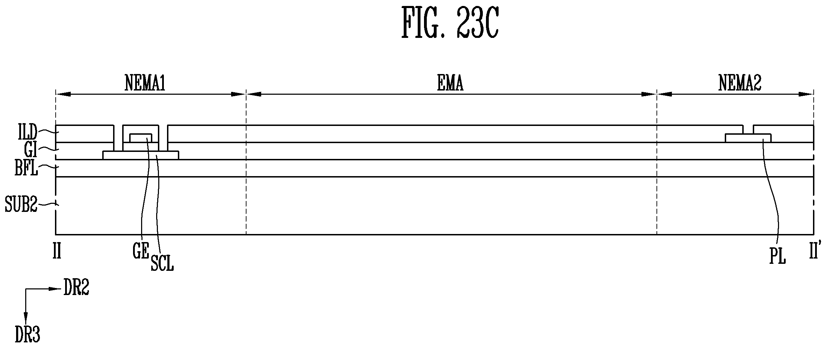

Then, in the method of FIG. 21, an interlayer insulating layer ILD may be formed over the entire second substrate SUB2, and contact holes exposing the semiconductor layer SCL and at least one of the first conductive patterns may be formed, as illustrated in FIG. 23c. For example, the contact holes may expose the first and second areas (e.g., source and drain areas) of the semiconductor layer SCL and a portion of the power line PL.

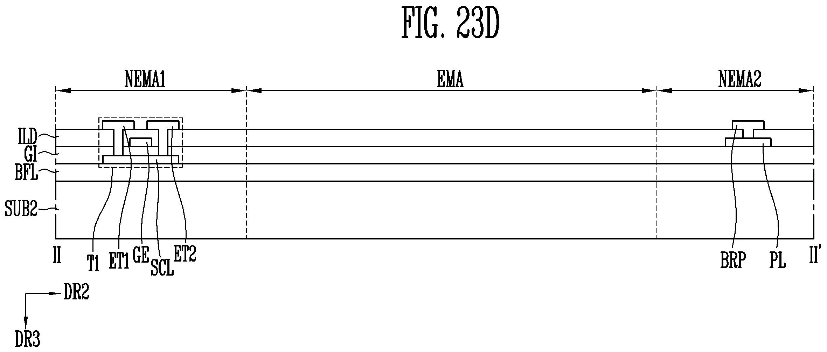

Then, in the method of FIG. 21, second conductive patterns may be formed on the interlayer insulating layer ILD, as illustrated in FIG. 23d. Here, the second conductive patterns may include first and second transistor electrodes ET1 and ET2 and a bridge pattern BRP. The first and second transistor electrodes ET1 and ET2 may respectively come into contact with the first and second areas of the semiconductor layer SCL through the contact holes, and the bridge pattern BRP may come into contact with the power line PL through the contact hole.

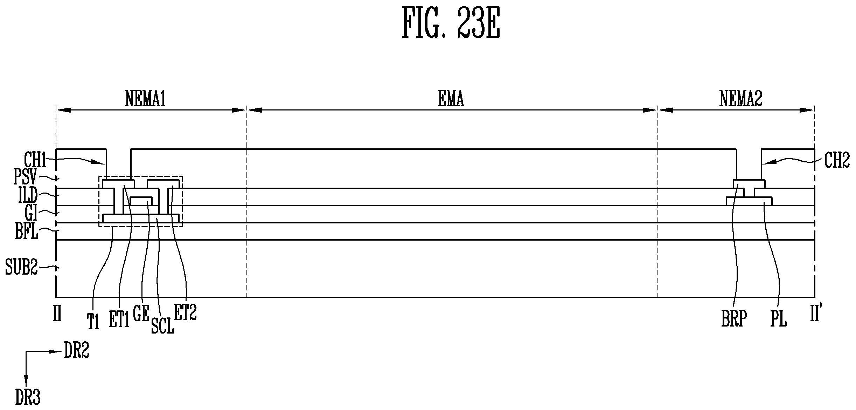

Then, in the method of FIG. 21, a passivation layer PSV may be formed over the entire second substrate SUB2 to cover the second conductive patterns and the interlayer insulating layer ILD, and contact holes CH1 and CH2 (or via holes) exposing at least some of the second conductive patterns may be formed, as illustrated in FIG. 23e.

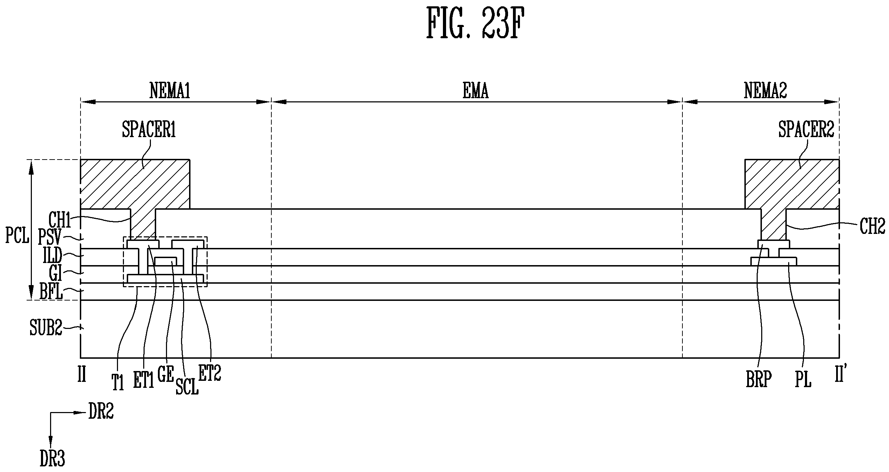

Then, in the method of FIG. 21, first and second conductive layers SPACER1 and SPACER2 may be formed on the passivation layer PSV in the first and second non-emission areas NEMA1 and NEMA2, as illustrated in FIG. 23f. The first conductive layer SPACER1 may be formed in the first non-emission area NEMA1, and may come into contact with the first transistor electrode ET1 through the first contact hole CH1. The second conductive layer SPACER2 may be formed in the second non-emission area NEMA2, and may come into contact with the bridge pattern BRP through the second contact hole CH2.

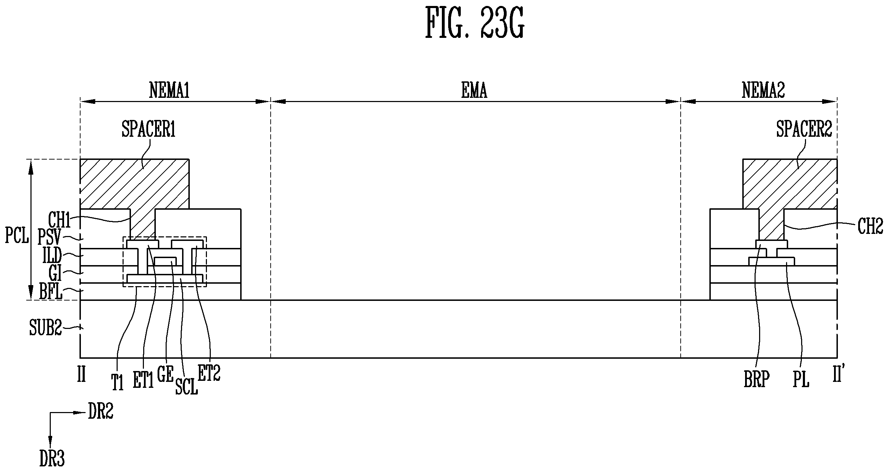

Then, in the method of FIG. 21, a groove may be formed by removing the insulating layers (that is, the buffer layer BFL, the gate insulating layer GI, the interlayer insulating layer ILD, and the passivation layer PSV) on the emission area EMA of the second substrate SUB2 through an etching process, or the like, as illustrated in FIG. 23g, and a transmissive component PR (refer to FIG. 10) may be formed in the groove. For example, in the method of FIG. 21, the transmissive component PR may be formed by supplying a transparent organic material to the groove through an inkjet printing method. Accordingly, the second panel STR2 having the cross-sectional structure of FIG. 10 may be manufactured.

Meanwhile, in FIGS. 10 and 23a to 23g, the transmissive component PR is illustrated as being formed by forming a groove in the emission area EMA of the second substrate SUB2 after forming the insulating layers (that is, the buffer layer BFL, the gate insulating layer GI, the interlayer insulating layer ILD, and the passivation layer PSV), but the present disclosure is not limited thereto.

For example, the method of FIG. 21 is configured such that, in the respective processes of forming the contact holes of the interlayer insulating layer ILD and forming the first and second contact holes CH1 and CH2 of the passivation layer PSV, a groove is formed by removing the corresponding insulating layer (e.g., the interlayer insulating layer ILD and the passivation layer PSV) on the emission area EMA of the second substrate SUB2, after which the transmissive component PR may be formed in the groove.

While the technical idea of the present disclosure is specifically described according to the above-described embodiments, it should be noted that the above-described embodiments are only for illustrative purposes rather than limiting the technical idea of the present disclosure. Also, it should be understood by those skilled in the art to which the present disclosure pertains that various alternations may be made herein without departing from the technical idea of the present disclosure.

The scope of the present disclosure is not limited by detailed descriptions of the present specification, and should be defined by the accompanying claims.

## Claims

1. A display device, comprising:
a first substrate (SUB1) including a first area (EMA) and a second area located at an edge of the first area;
a first electrode (ELT1) and a second electrode (ELT2) disposed on the first substrate and spaced apart from each other;
light emitting elements (LD) disposed between the first electrode and the second electrode in the first area;
a first conductive layer (SPACER1) disposed on the first electrode in the second area;
a pixel circuit layer (PCL) disposed on the first conductive layer in the second area and including a transistor (T1) coupled to the first conductive layer;
a second substrate (SUB2) disposed on the pixel circuit layer;
a first contact electrode (CNE1) configured to couple a first end (EP1) of each of the light emitting elements to the first electrode (ELT1);
a second contact electrode (CNE2) configured to couple a second end (EP2) of each of the light emitting elements to the second electrode (ELT2); and
an insulating layer (INS3) disposed on the first contact electrode (CNE1) and the second contact electrode (CNE2),
wherein a thickness of the first conductive layer is greater than an average thickness of the insulating layer.

2. A display device according to claim 1, further comprising:
a first partition wall (PW1) interposed between the first substrate (SUB1) and the first electrode (ELT1) in the first area (EMA);
a second partition wall (PW2) (PW2) interposed between the first substrate and the second electrode (ELT2) in the first area; and
a third partition wall (PW3) interposed between the first substrate and the first electrode in the second area,
wherein the light emitting elements (LD) are disposed between the first partition wall and the second partition wall.

3. A display device according to claim 2, wherein the pixel circuit layer (PCL) further includes a transmissive component (PR) disposed to overlap the first area (EMA) of the first substrate (SUB1) and configured to transmit at least some of light emitted from the light emitting elements (LD).

4. A display device according to any preceding claim, wherein the first contact electrode (CNE1) is interposed between the first electrode (ELT1) and the first conductive layer (SPACER1) in the second area.

5. A display device according to any preceding claim, wherein the insulating layer does not overlap the first conductive layer (SPACER1).

6. A display device according to any one of claims 3 to 5, wherein:
the pixel circuit layer (PCL) further includes
a via layer (PSV) disposed on the first conductive layer (SPACER1) ;
a first transistor electrode (ET1) disposed on the via layer; and
a semiconductor pattern (SCL) disposed on the first transistor electrode,
the first transistor electrode and the semiconductor pattern form the transistor (T1), and
the first conductive layer (SPACER1) comes into contact with the first transistor electrode through a contact hole (CH1) that exposes the first transistor electrode by passing through the via layer, optionally wherein the via layer includes a light-blocking material that absorbs or blocks light emitted from the light emitting elements (LD).

7. A display device according to any one of claims 3 to 6, further comprising:
a second conductive layer (SPACER2) disposed on the second electrode (ELT2) in the second area and spaced apart from the first conductive layer (SPACER1),
wherein the pixel circuit layer (PCL) further includes a power line (PL) disposed on the second conductive layer in the second area and coupled to the second conductive layer, optionally wherein:
the first substrate (SUB1) includes a plurality of pixel areas configured to display different monochromic colors, each of the pixel areas including the first area (EMA) and the second area,
the first conductive layer (SPACER1) is independently disposed in each of the pixel areas, and
the second conductive layer is disposed across at least two pixel areas, among the pixel areas.

8. A display device according to any one of claims 3 to 6, wherein the transmissive component (PR) covers the second electrode (ELT2) in the second area, optionally wherein:
the first substrate (SUB1) further includes a display area (DA) in which an image is displayed and a non-display area (NDA) located on one side of the display area,
the display area includes a plurality of pixel areas configured to display different monochromic colors, each of the pixel areas including the first area (EMA) and the second area,
the second electrode (ELT2) extends to the non-display area, and
the pixel circuit layer (PCL) further includes a power line (PL) disposed in the non-display area; and a second conductive layer (SPACER2) disposed between the second electrode and the power line in the non-display area and configured to couple the second electrode to the power line.

9. A display device according to any one of claims 3 to 8, wherein:
(i) the transmissive component (PR) includes a color filter material configured to block some wavelength bands of light emitted from the light emitting elements (LD); and/or
(ii) the transmissive component includes a quantum dot configured to convert a color of light emitted from the light emitting elements.

10. A display device according to any one of claims 2 to 9, further comprising:
a bank disposed along an edge of the first area (EMA) on the second area of the first substrate (SUB1) and configured to define the first area,
wherein the bank does not overlap the first conductive layer (SPACER1).

11. A display device according to claim 9 or claim 10, wherein a sum of a thickness of the first conductive layer (SPACER1) and a thickness of the third partition wall (PW3) is greater than a thickness of the bank.

12. A display device according to any one of claims 1 to 11, wherein each of the light emitting elements (LD) is a rod-type light emitting diode having a size ranging from a nanoscale to a microscale.

13. A method of manufacturing a display device, comprising:
preparing a first panel (STR1) including a light emitting element layer (LDL) formed on a first substrate (SUB1);
preparing a second panel (STR2) including a pixel circuit layer (PCL) formed on a second substrate (SUB2); and
bonding the first panel and the second panel such that the light emitting element layer and the pixel circuit layer come into contact with each other,
wherein:
the light emitting element layer includes a first substrate (SUB1), first and second electrodes (ELT1, ELT2) disposed to be spaced apart from each other on the first substrate, and a plurality of light emitting elements (LD) disposed between the first and second electrodes,
the pixel circuit layer includes a second substrate, a transistor disposed on the second substrate, and a first conductive layer (SPACER1) disposed on the transistor; and
a first contact electrode (CNE1) configured to couple a first end (EP1) of each of the light emitting elements to the first electrode (ELT1);
a second contact electrode (CNE2) configured to couple a second end (EP2) of each of the light emitting elements to the second electrode (ELT2); and
an insulating layer (INS3) disposed on the first contact electrode (CNE1) and the second contact electrode (CNE2),
wherein a thickness of the first conductive layer is greater than an average thickness of the insulating layer.

14. A method according to claim 13, wherein the pixel circuit layer (PCL) further includes a transmissive component (PR) overlapping the light emitting elements of (LD) the first panel (STR1) and configured to transmit at least some of light emitted from the light emitting elements, optionally wherein preparing the second panel (STR2) comprises:
forming the transistor on the second substrate (SUB2);
forming the first conductive layer (SPACER1) on the transistor;
forming a groove in the pixel circuit layer corresponding to the transmissive component; and
forming the transmissive component by supplying a transparent organic material to the groove.

## Patentansprüche

1. Anzeigevorrichtung, umfassend:
ein erstes Substrat (SUB1), das einen ersten Bereich (EMA) und einen zweiten Bereich, der sich an einem Rand des ersten Bereichs befindet, einschließt;
eine erste Elektrode (ELT1) und eine zweite Elektrode (ELT2), die auf dem ersten Substrat angeordnet und voneinander beabstandet sind;
lichtemittierende Elemente (LD), die im ersten Bereich zwischen der ersten Elektrode und der zweiten Elektrode angeordnet sind;
eine erste leitfähige Schicht (SPACER1), die im zweiten Bereich auf der ersten Elektrode angeordnet ist;
eine Pixelschaltungsschicht (PCL), die im zweiten Bereich auf der ersten leitfähigen Schicht angeordnet ist und einen Transistor (T1), der mit der ersten leitfähigen Schicht gekoppelt ist, einschließt;
ein zweites Substrat (SUB2), das auf der Pixelschaltungsschicht angeordnet ist;
eine erste Kontaktelektrode (CNE1), die dafür konfiguriert ist, ein erstes Ende (EP1) eines jeden der lichtemittierenden Elemente mit der ersten Elektrode (ELT1) zu koppeln;
eine zweite Kontaktelektrode (CNE2), die dafür konfiguriert ist, ein zweites Ende (EP2) eines jeden der lichtemittierenden Elemente mit der zweiten Elektrode (ELT2) zu koppeln; und
eine Isolierschicht (INS3), die auf der ersten Kontaktelektrode (CNE1) und der zweiten Kontaktelektrode (CNE2) angeordnet ist,
wobei eine Dicke der ersten leitfähigen Schicht größer als eine durchschnittliche Dicke der Isolierschicht ist.

2. Anzeigevorrichtung nach Anspruch 1, ferner umfassend:
eine erste Trennwand (PW1), die im ersten Bereich (EMA) zwischen dem ersten Substrat (SUB1) und der ersten Elektrode (ELT1) dazwischengesetzt ist;
eine zweite Trennwand (PW2), die im ersten Bereich zwischen dem ersten Substrat und der zweiten Elektrode (ELT2) dazwischengesetzt ist; und
eine dritte Trennwand (PW3), die im zweiten Bereich zwischen dem ersten Substrat und der ersten Elektrode dazwischengesetzt ist,
wobei die lichtemittierenden Elemente (LD) zwischen der ersten Trennwand und der zweiten Trennwand angeordnet sind.

3. Anzeigevorrichtung nach Anspruch 2, wobei die Pixelschaltungsschicht (PCL) ferner eine durchlässige Komponente (PR) einschließt, die so angeordnet ist, dass sie den ersten Bereich (EMA) des ersten Substrats (SUB1) überlappt, und dafür konfiguriert ist, mindestens einen Teil des von den lichtemittierenden Elementen (LD) emittierten Lichts zu übertragen.

4. Anzeigevorrichtung nach einem der vorhergehenden Ansprüche, wobei die erste Kontaktelektrode (CNE1) im zweiten Bereich zwischen der ersten Elektrode (ELT1) und der ersten leitfähigen Schicht (SPACER1) dazwischengesetzt ist.

5. Anzeigevorrichtung nach einem der vorhergehenden Ansprüche, wobei die Isolierschicht die erste leitfähige Schicht (SPACER1) nicht überlappt.

6. Anzeigevorrichtung nach einem der Ansprüche 3 bis 5, wobei:
die Pixelschaltungsschicht (PCL) ferner einschließt:
eine Durchkontaktierungsschicht (PSV), die auf der ersten leitfähigen Schicht (SPACER1) angeordnet ist;
eine erste Transistorelektrode (ET1), die auf der Durchkontaktierungsschicht angeordnet ist; und
eine Halbleiterstruktur (SCL), die auf der ersten Transistorelektrode angeordnet ist,
die erste Transistorelektrode und die Halbleiterstruktur den Transistor (T1) bilden, und
die erste leitfähige Schicht (SPACER1) durch ein Kontaktloch (CH1), das die erste Transistorelektrode freilegt, indem es durch die Durchkontaktierungsschicht hindurchgeht, mit der ersten Transistorelektrode in Kontakt kommt, wobei optional die Durchkontaktierungsschicht ein lichtblockierendes Material einschließt, das von den lichtemittierenden Elementen (LD) emittiertes Licht absorbiert oder blockiert.

7. Anzeigevorrichtung nach einem der Ansprüche 3 bis 6, ferner umfassend:
eine zweite leitfähige Schicht (SPACER2), die im zweiten Bereich auf der zweiten Elektrode (ELT2) angeordnet und von der ersten leitfähigen Schicht (SPACER1) beabstandet ist,
wobei die Pixelschaltungsschicht (PCL) ferner eine Stromversorgungsleitung (PL) einschließt, die im zweiten Bereich auf der zweiten leitfähigen Schicht angeordnet und mit der zweiten leitfähigen Schicht gekoppelt ist, wobei optional:
das erste Substrat (SUB1) eine Vielzahl von Pixelbereichen einschließt, die dafür konfiguriert sind, unterschiedliche monochrome Farben anzuzeigen, wobei jeder der Pixelbereiche den ersten Bereich (EMA) und den zweiten Bereich einschließt,
die erste leitfähige Schicht (SPACER1) unabhängig in jedem der Pixelbereiche angeordnet ist, und
die zweite leitfähige Schicht über mindestens zwei Pixelbereiche aus den Pixelbereichen hinweg angeordnet ist.

8. Anzeigevorrichtung nach einem der Ansprüche 3 bis 6, wobei im zweiten Bereich die durchlässige Komponente (PR) die zweite Elektrode (ELT2) bedeckt, wobei optional:
das erste Substrat (SUB1) ferner einen Anzeigebereich (DA), in dem ein Bild angezeigt wird, und einen Nicht-Anzeigebereich (NDA), der sich auf einer Seite des Anzeigebereichs befindet, einschließt,
der Anzeigebereich eine Vielzahl von Pixelbereichen einschließt, die dafür konfiguriert sind, unterschiedliche monochrome Farben anzuzeigen, wobei jeder der Pixelbereiche den ersten Bereich (EMA) und den zweiten Bereich einschließt,
die zweite Elektrode (ELT2) sich bis zum Nicht-Anzeigebereich erstreckt, und
die Pixelschaltungsschicht (PCL) ferner einschließt: eine Stromversorgungsleitung (PL), die im Nicht-Anzeigebereich angeordnet ist; und eine zweite leitfähige Schicht (SPACER2), im Nicht-Anzeigebereich die zwischen der zweiten Elektrode und der Stromversorgungsleitung angeordnet und dafür konfiguriert ist, die zweite Elektrode mit der Stromversorgungsleitung zu koppeln.

9. Anzeigevorrichtung nach einem der Ansprüche 3 bis 8, wobei
(i) die durchlässige Komponente (PR) ein Farbfiltermaterial einschließt, das dafür konfiguriert ist, einige Wellenlängenbänder des von den lichtemittierenden Elementen (LD) emittierten Lichts zu blockieren; und/oder
(ii) die durchlässige Komponente einen Quantenpunkt einschließt, der dafür konfiguriert ist, eine Farbe des von den lichtemittierenden Elementen emittierten Lichts umzuwandeln.

10. Anzeigevorrichtung nach einem der Ansprüche 2 bis 9, ferner umfassend:
eine Bank, die entlang eines Randes des ersten Bereichs (EMA) auf dem zweiten Bereich des ersten Substrats (SUB1) angeordnet und dafür konfiguriert ist, den ersten Bereich zu definieren,
wobei die Bank die erste leitfähige Schicht (SPACER1) nicht überlappt.

11. Anzeigevorrichtung nach Anspruch 9 oder Anspruch 10, wobei eine Summe aus einer Dicke der ersten leitfähigen Schicht (SPACER1) und einer Dicke der dritten Trennwand (PW3) größer als eine Dicke der Bank ist.

12. Anzeigevorrichtung nach einem der Ansprüche 1 bis 11, wobei jedes der lichtemittierenden Elemente (LD) eine Leuchtdiode vom Stäbchentyp mit einer Größe im Nanometer- bis Mikrobereich ist.

13. Verfahren zur Herstellung einer Anzeigevorrichtung, umfassend:
Anfertigen einer ersten Tafel (STR1), die eine Schicht von lichtemittierenden Elementen (LDL) einschließt, die auf einem ersten Substrat (SUB1) ausgebildet ist;
Anfertigen einer zweiten Tafel (STR2), die eine Pixelschaltungsschicht (PCL) einschließt, die auf einem zweiten Substrat (SUB2) ausgebildet ist; und
Verbinden der ersten Tafel und der zweiten Tafel, sodass die Schicht von lichtemittierenden Elementen und die Pixelschaltungsschicht einander berühren,
wobei:
die Schicht von lichtemittierenden Elementen einschließt: ein erstes Substrat (SUB1), eine erste und eine zweite Elektrode (ELT1, ELT2), die so auf dem ersten Substrat angeordnet sind, dass sie voneinander beabstandet sind, und eine Vielzahl von lichtemittierenden Elementen (LD), die zwischen der ersten und der zweiten Elektrode angeordnet sind,
die Pixelschaltungsschicht einschließt: ein zweites Substrat, einen auf dem zweiten Substrat angeordneten Transistor und eine auf dem Transistor angeordnete erste leitfähige Schicht (SPACER1); und
eine erste Kontaktelektrode (CNE1), die dafür konfiguriert ist, ein erstes Ende (EP1) eines jeden der lichtemittierenden Elemente mit der ersten Elektrode (ELT1) zu koppeln;
eine zweite Kontaktelektrode (CNE2), die dafür konfiguriert ist, ein zweites Ende (EP2) eines jeden der lichtemittierenden Elemente mit der zweiten Elektrode (ELT2) zu koppeln; und
eine Isolierschicht (INS3), die auf der ersten Kontaktelektrode (CNE1) und der zweiten Kontaktelektrode (CNE2) angeordnet ist,
wobei eine Dicke der ersten leitfähigen Schicht größer als eine durchschnittliche Dicke der Isolierschicht ist.

14. Verfahren nach Anspruch 13, wobei die Pixelschaltungsschicht (PCL) ferner eine durchlässige Komponente (PR) einschließt, welche die lichtemittierenden Elemente (LD) der ersten Tafel (STR1) überlappt und dafür konfiguriert ist, mindestens einen Teil des von den lichtemittierenden Elementen emittierten Lichts zu übertragen, wobei optional das Anfertigen der zweiten Tafel (STR2) umfasst:
Ausbilden des Transistors auf dem zweiten Substrat (SUB2);
Ausbilden der ersten leitfähigen Schicht (SPACER1) auf dem Transistor;
Ausbilden einer Furche, die der durchlässigen Komponente entspricht, in der Pixelschaltungsschicht; und
Ausbilden der durchlässigen Komponente durch Zuführen eines transparenten organischen Materials zu der Furche.

## Revendications

1. Dispositif d'affichage, comprenant :
un premier substrat (SUB1) incluant une première zone (EMA) et une seconde zone localisée au niveau d'un bord de la première zone ;
une première électrode (ELT1) et une seconde électrode (ELT2) disposées sur le premier substrat et espacées à l'écart l'une de l'autre ;
des éléments électroluminescents (LD) disposés entre la première électrode et la seconde électrode dans la première zone ;
une première couche conductrice (SPACER1) disposée sur la première électrode dans la seconde zone ;
une couche de circuit de pixel (PCL) disposée sur la première couche conductrice dans la seconde zone et incluant un transistor (T1) couplé à la première couche conductrice ;
un second substrat (SUB2) disposé sur la couche de circuit de pixel ;
une première électrode de contact (CNE1) configurée pour accoupler une première extrémité (EP1) de chacun des éléments électroluminescents à la première électrode (ELT1) ;
une seconde électrode de contact (CNE2) configurée pour coupler une seconde extrémité (EP2) de chacun des éléments électroluminescents à la seconde électrode (ELT2) ; et
une couche isolante (INS3) disposée sur la première électrode de contact (CNE1) et la seconde électrode de contact (CNE2),
dans lequel une épaisseur de la première couche conductrice est supérieure à une épaisseur moyenne de la couche isolante.

2. Dispositif d'affichage selon la revendication 1, comprenant en outre :
une première paroi de partition (PW1) interposée entre le premier substrat (SUB1) et la première électrode (ELT1) dans la première zone (EMA) ;
une seconde paroi de partition (PW2) interposée entre le premier substrat et la seconde électrode (ELT2) dans la première zone ; et
une troisième paroi de partition (PW3) interposée entre le premier substrat et la première électrode dans la seconde zone,
dans lequel les éléments électroluminescents (LD) sont disposés entre la première paroi de partition et la seconde paroi de partition.

3. Dispositif d'affichage selon la revendication 2, dans lequel la couche de circuit de pixel (PCL) inclut en outre un composant transmissif (PR) disposé pour chevaucher la première zone (EMA) du premier substrat (SUB1) et configuré pour transmettre au moins une partie de la lumière émise depuis les éléments électroluminescents (LD).

4. Dispositif d'affichage selon l'une quelconque des revendications précédentes, dans lequel la première électrode de contact (CNE1) est interposée entre la première électrode (ELT1) et la première couche conductrice (SPACER1) dans la seconde zone.

5. Dispositif d'affichage selon l'une quelconque des revendications précédentes, dans lequel la couche isolante ne chevauche pas la première couche conductrice (SPACER1).

6. Dispositif d' affichage selon l'une quelconque des revendications 3 à 5, dans lequel :
la couche de circuit de pixel (PCL) inclut en outre
une couche de trous d'interconnexion (PSV) disposée sur la première couche conductrice (SPACER1) ;
une première électrode de transistor (ET1) disposée sur la couche de trous d'interconnexion ; et
un motif semi-conducteur (SCL) disposé sur la première électrode de transistor,
la première électrode de transistor et le motif semi-conducteur forment le transistor (T1), et
la première couche conductrice (SPACER1) entre en contact avec la première électrode de transistor à travers un trou de contact (CH1) qui expose la première électrode de transistor en passant à travers la couche de trous d'interconnexion, facultativement dans lequel la couche de trous d'interconnexion inclut un matériau bloquant la lumière qui absorbe ou qui bloque la lumière émise depuis les éléments électroluminescents (LD).

7. Dispositif d'affichage selon l'une quelconque des revendications 3 à 6, comprenant en outre :
une seconde couche conductrice (SPACER2) disposée sur la seconde électrode (ELT2) dans la seconde zone et espacée à l'écart de la première couche conductrice (SPACER1),
dans lequel la couche de circuit de pixel (PCL) inclut en outre une ligne d'alimentation (PL) disposée sur la seconde couche conductrice dans la seconde zone et couplée à la seconde couche conductrice, facultativement dans lequel :
le premier substrat (SUB1) inclut une pluralité de zones de pixels configurées pour afficher différentes couleurs monochromes, chacune des zones de pixels incluant la première zone (EMA) et la seconde zone,
la première couche conductrice (SPACER1) est indépendamment disposée sur chacune des zones de pixels, et
la seconde couche conductrice est disposée à travers au moins deux zones de pixels, parmi les zones de pixels.

8. Dispositif d'affichage selon l'une quelconque des revendications 3 à 6, dans lequel le composant transmissif (PR) recouvre la seconde électrode (ELT2) dans la seconde zone, facultativement dans lequel :
le premier substrat (SUB1) inclut en outre une zone d'affichage (DA) dans laquelle une image est affichée et une zone non d'affichage (NDA) localisée sur un côté de la zone d'affichage,
la zone d'affichage inclut une pluralité de zones de pixels configurées pour afficher différentes couleurs monochromes, chacune des zones de pixels incluant la première zone (EMA) et la seconde zone,
la seconde électrode (ELT2) s'étend jusqu'à la zone non d'affichage, et
la couche de circuit de pixel (PCL) inclut en outre une ligne d'alimentation (PL) disposée dans la zone non d'affichage ; et une seconde couche conductrice (SPACER2) disposée entre la seconde électrode et la ligne d'alimentation dans la zone non d'affichage et configurée pour coupler la seconde électrode à la ligne d'alimentation.

9. Dispositif d'affichage selon l'une quelconque des revendications 3 à 8, dans lequel :
(i) le composant transmissif (PR) inclut un matériau filtre de couleur configuré pour bloquer certaines bandes de longueur d'onde de la lumière émise depuis les éléments électroluminescents (LD) ; et/ou
(ii) le composant transmissif inclut un point quantique configuré pour convertir une couleur de lumière émise depuis les éléments électroluminescents.

10. Dispositif d'affichage selon l'une quelconque des revendications 2 à 9, comprenant en outre :
un banc disposé le long d'un bord de la première zone (EMA) sur la seconde zone du premier substrat (SUB1) et configuré pour définir la première zone,
dans lequel le banc ne chevauche pas la première couche conductrice (SPACER1).

11. Dispositif d'affichage selon la revendication 9 ou la revendication 10, dans lequel une somme d'une épaisseur de la première couche conductrice (SPACER1) et d'une épaisseur de la troisième paroi de partition (PW3) est supérieure à une épaisseur du banc.

12. Dispositif d'affichage selon l'une quelconque des revendications 1 à 11, dans lequel chacun des éléments électroluminescents (LD) est une diode électroluminescente de type tige ayant une taille s'étendant d'une échelle nanométrique à une échelle micrométrique.

13. Procédé de fabrication d'un dispositif d'affichage, comprenant les étapes consistant à :
préparer un premier panneau (STR1) incluant une couche d'élément électroluminescent (LDL) formée sur un premier substrat (SUB1) ;
préparer un second panneau (STR2) incluant une couche de circuit de pixel (PCL) formée sur un second substrat (SUB2) ; et
lier le premier panneau et le second panneau de sorte que la couche d'élément électroluminescent et la couche de circuit de pixel entrent en contact l'une avec l'autre,
dans lequel :
la couche d'élément électroluminescent inclut un premier substrat (SUB1), une première et une seconde électrode (ELT1, ELT2) disposées pour être espacées à l'écart l'une de l'autre sur le premier substrat, et une pluralité d'éléments électroluminescents (LD) disposés entre la première et la seconde électrode,
la couche de circuit de pixel inclut un second substrat, un transistor disposé sur le second substrat, et une première couche conductrice (SPACER1) disposée sur le transistor ; et
une première électrode de contact (CNE1) configurée pour coupler une première extrémité (EP1) de chacun des éléments électroluminescents à la première électrode (ELT1) ;
une seconde électrode de contact (CNE2) configurée pour coupler une seconde extrémité (EP2) de chacun des éléments électroluminescents à la seconde électrode (ELT2) ; et
une couche isolante (INS3) disposée sur la première électrode de contact (CNE1) et la seconde électrode de contact (CNE2),
dans lequel une épaisseur de la première couche conductrice est supérieure à une épaisseur moyenne de la couche isolante.

14. Procédé selon la revendication 13, dans lequel la couche de circuit de pixel (PCL) inclut en outre un composant transmissif (PR) chevauchant les éléments électroluminescents (LD) du premier panneau (STR1) et configuré pour transmettre au moins une partie de la lumière émise depuis les éléments électroluminescents, facultativement dans lequel la préparation du second panneau (STR2) comprend les étapes consistant à :
former le transistor sur le second substrat (SUB2) ;
former la première couche conductrice (SPACER1) sur le transistor ;
former une rainure dans la couche de circuit de pixel correspondant au composant transmissif ; et
former le composant transmissif en alimentant un matériau organique transparent au niveau de la rainure.
